# EUROPEAN PATENT APPLICATION

(11) **EP 3 296 845 A1**
(43) Date of publication of application: **21.03.2018**
(21) Application number: 16792549.4
(22) Date of filing: 26.04.2016
(51) Int. Cl.: G06F 3/041, B32B 1/00, B32B 15/08, C23C 18/18, G06F 3/044, H01B 5/14, H01B 13/00, H05K 3/00, H05K 3/18

(54) **CONDUCTIVE LAMINATE MANUFACTURING METHOD, CONDUCTIVE LAMINATE, SUBSTRATE WITH PLATE-LAYER PRECURSOR LAYER, SUBSTRATE WITH PLATE LAYER, AND TOUCH SENSOR**

(30) Priority: 11.05.2015 JP 2015096754; 19.01.2016 JP 2016008193
(71) Applicant: FUJIFILM Corporation, Tokyo 106-8620 (JP)
(72) Inventor: TSUKAMOTO Naoki, Ashigara-kami-gun Kanagawa 258-8577 (JP)
(74) Representative: Hoffmann Eitle
(86) International application number: PCT/JP2016/063049
(87) International publication number: WO 2016/181824

(57) **Abstract**

An object of the present invention is to provide a method of simply manufacturing a conductive laminate which has a three-dimensional shape including a curved surface and in which a metal layer is disposed on the curved surface, a conductive laminate, a plated layer-attached substrate, a plated layer precursor layer-attached substrate, and a touch sensor.

The method of manufacturing the conductive laminate having three-dimensional shape including a curved surface according to the present invention includes: Step A of forming a pattern-shaped plated layer precursor layer including a predetermined compound on a substrate to obtain a plated layer precursor layer-attached substrate; Step B of deforming a plated layer precursor layer-attached substrate such that at least a portion of the plated layer precursor layer is deformed to form a three-dimensional shape including a curved surface; Step C of applying energy to the plated layer precursor layer to form a pattern-shaped plated layer; and Step D of applying a plating catalyst or a precursor thereof to the pattern-shaped plated layer, and then performing a plating treatment to form a pattern-shaped metal layer on the plated layer.

## Description

### BACKGROUND OF THE INVENTION

### 1. Field of the Invention

The present invention relates to a method of manufacturing a conductive laminate, a conductive laminate, a plated layer precursor layer-attached substrate, a plated layer-attached substrate, and a touch sensor.

### 2. Description of the Related Art

A conductive laminate in which a conductive film (conductive thin lines) is formed on the substrate is used in various uses. Particularly, recently, in accordance with a rise in a loading ratio of a touch panel or a touch pad to a mobile phone, a mobile game machine, or the like, the demand for a conductive laminate for an electrostatic capacitance type touch sensor capable of multi-point detection has rapidly expanded.

Meanwhile, in accordance with the popularization of a touch panel or a touch pad in recent years, the types of devices that mount a touch panel or a touch pad have diversified, and a touch panel or a touch pad of which a touch surface is a curved surface has been proposed in order to enhance the operability of the device.

For example, in JP2013-246741A, discloses "an electrostatic capacitance type touch panel having a touch surface in a three-dimensional curved surface shape which is a laminate at least including a transparent base material sheet and a main electrode layer having a plurality of main electrode areas formed by using conductive ink in which an elongation percentage of a dry coating film is 10% or less, and visible light transmittance is 90% or greater on one surface of the base material sheet, in which the laminate is a formed product including a three-dimensional curved surface by a drawing process after heat softening".

Specifically, a method of manufacturing a three-dimensional curved surface touch panel disclosed in JP2013-246741A includes providing a main electrode layer having a plurality of main electrode areas formed by using conductive ink including an organic conductive material on the surface of the transparent base material sheet, providing an auxiliary electrode layer having an auxiliary electrode area at a position that becomes a peripheral portion in a three-dimensional curved surface by drawing process on the main electrode layer, forming into a three-dimensional curved surface by the drawing process in a state in which the laminate including these three layers is subjected to heat softening, and obtaining a curved surface shaped formed product by cooling or allowing to cool.

### SUMMARY OF THE INVENTION

However, since the resistance value of the organic material is comparatively high as 50 Ω/□ or greater and the conductive layer is stretched in a case of deformation, the conductive ink layer (conductive layer) formed of conductive ink including organic conductive material such as carbon nanotube or poly(3,4-ethylenedioxythiophene) (PEDOT) which is used in the manufacturing method in JP2013-246741A tends to have a higher resistance value, and thus there is a problem in an industrial point of view.

In contrast, a metal layer made of metal has a lower resistance value than an organic conductive material as low as 1 Ω/□ or less even in a mesh shape having an opening ratio of 90% or greater, and conductivity characteristics are excellent.

Meanwhile, in a case where a three-dimensional shape is provided by using a conductive film having a metal layer formed on a resin substrate by a metal plating treatment, metal vapor deposition, or the like and by the drawing process as in the method of JP2013-246741A, the metal layer cannot follow the elongation of the resin substrate and breaks in many cases.

Therefore, in view of these circumstances, an object of the present invention is to provide a method of simply manufacturing a conductive laminate which has a three-dimensional shape including a curved surface and which has a metal layer disposed on the curved surface.

Another object of the present invention is to provide the conductive laminate, and a touch sensor including a conductive laminate.

The present inventors have diligently conducted studies on the above problems and have found that the problems can be solved by forming a plated layer precursor layer or a plated layer on a substrate, deforming a substrate having the plated layer precursor layer or the plated layer, forming a three-dimensional shape, and performing a plating treatment.

That is, the present inventors have found that the above problems can be solved by the following configurations.
(1) A method of manufacturing a conductive laminate having a three-dimensional shape including a curved surface, comprising:
   Step A of forming a pattern-shaped plated layer precursor layer having a functional group interacting with a plating catalyst or a precursor thereof and a polymerizable group on a substrate to obtain a plated layer precursor layer-attached substrate;
   Step B of deforming the plated layer precursor layer-attached substrate such that at least a portion of the plated layer precursor layer is deformed to be formed into a three-dimensional shape including a curved surface;
   Step C of applying energy to the plated layer precursor layer to form a pattern-shaped plated layer; and
   Step D of performing a plating treatment on the pattern-shaped plated layer to form a pattern-shaped metal layer on the plated layer;
   in which Step E of applying a plating catalyst or a precursor thereof to the pattern-shaped plated layer is further included after Step C and before Step D, or a plating catalyst or a precursor thereof is included in the pattern-shaped plated layer precursor layer of Step A.
(2) The method of manufacturing a conductive laminate according to (1),
   in which Step A is a step of forming the pattern-shaped plated layer precursor layer including Compound X or Composition Y on a substrate to obtain the plated layer precursor layer-attached substrate, and
   in which Step E of applying a plating catalyst or a precursor thereof to the pattern-shaped plated layer is further included after Step C and before Step D,
   Compound X or Composition Y:
   Compound X: a compound having a functional group interacting with a plating catalyst or a precursor thereof and a polymerizable group, and
   Composition Y: a composition including a compound having a functional group interacting with a plating catalyst or a precursor thereof and a compound having a polymerizable group.
(3) The method of manufacturing a conductive laminate according to (1) or (2), in which an elongation at break of each of the substrate and the plated layer precursor layer at 200°C is 50% or greater.
(4) A method of manufacturing a conductive laminate having a three-dimensional shape including a curved surface, comprising:
   Step F of forming a pattern-shaped plated layer having a functional group interacting with a plating catalyst or a precursor thereof on a substrate to obtain a plated layer-attached substrate;
   Step G of deforming the plated layer-attached substrate such that at least a portion of the plated layer is deformed to be formed into a three-dimensional shape including a curved surface; and
   Step H of performing a plating treatment on the pattern-shaped plated layer to form a pattern-shaped metal layer on the plated layer;
   in which Step I of applying a plating catalyst or a precursor thereof to the pattern-shaped plated layer is further included after Step G and before Step H, or a plating catalyst or a precursor thereof is included in the pattern-shaped plated layer of Step F.
(5) The method of manufacturing a conductive laminate according to (4), in which an elongation at break of each of the substrate and the plated layer at 200°C is 50% or greater.
(6) The method of manufacturing a conductive laminate according to (4) or (5), in which a width of the pattern-shaped metal layer is 10 µm or less.
(7) The method of manufacturing a conductive laminate according to any one of (1) to (6), in which the plating treatment includes an electroless plating treatment.
(8) A conductive laminate comprising:
   a substrate having a three-dimensional shape including a curved surface;
   a pattern-shaped plated layer which is disposed at least on a curved surface of the substrate and which includes a functional group interacting with a plating catalyst or a precursor thereof; and
   a pattern-shaped metal layer disposed on the plated layer.
(9) The conductive laminate according to (8),
   in which the plated layer is a layer formed by applying energy to a pattern-shaped plated layer precursor layer including Compound X or Composition Y,
   Compound X: a compound having a functional group interacting with a plating catalyst or a precursor thereof and a polymerizable group, and
   Composition Y: a composition including a compound having a functional group interacting with a plating catalyst or a precursor thereof and a compound having a polymerizable group.
(10) The conductive laminate according to (8) or (9), in which the metal layer is a layer formed by performing a plating treatment after a plating catalyst or a precursor thereof is applied to the plated layer.
(11) A plated layer precursor layer-attached substrate used in manufacturing of a conductive laminate having a three-dimensional shape including a curved surface; the plated layer precursor layer-attached substrate comprising:
   a substrate; and
   a pattern-shaped plated layer precursor layer which is disposed at least at a position of the substrate on which the curved surface is formed and which has a functional group interacting with a plating catalyst or a precursor thereof and a polymerizable group.
(12) A plated layer-attached substrate used in manufacturing of a conductive laminate having a three-dimensional shape including a curved surface, the plated layer-attached substrate comprising:
   a substrate; and
   a pattern-shaped plated layer which is disposed at least at a position of the substrate on which the curved surface is formed and which includes a functional group interacting with a plating catalyst or a precursor thereof.
(13) A plated layer-attached substrate comprising:
   a substrate having a three-dimensional shape including a curved surface; and
   a pattern-shaped plated layer which is disposed at least on a curved surface of the substrate and which includes a functional group interacting with a plating catalyst or a precursor thereof.
(14) The conductive laminate according to any one of (8) to (10), used as a heating element.
(15) A touch sensor comprising:
   a conductive laminate manufactured by the manufacturing method according to any one of (1) to (7) or the conductive laminate according to any one of (8) to (10).

According to the present invention, it is possible to provide a method of simply manufacturing a conductive laminate having a three-dimensional shape including a curved surface and having a metal layer disposed on the curved surface.

According to the present invention, it is possible to provide the conductive laminate, a plated layer precursor layer-attached substrate, a plated layer precursor layer-attached substrate, and a touch sensor including a conductive laminate.

### BRIEF DESCRIPTION OF THE DRAWINGS

Fig. 1A is a partial sectional view of a laminate obtained in Step A1 according to a first embodiment of a method of manufacturing a conductive laminate.
Fig. 1B is a perspective view of a laminate obtained in Step A1.
Fig. 1C is a partially enlarged plan view of the patterned plated layer precursor layer.
Fig. ID is a partially enlarged plan view of another aspect of the patterned plated layer precursor layer.
Fig. 2A is a partial sectional view of a laminate obtained in Step B1 according to the first embodiment of the method of manufacturing the conductive laminate.
Fig. 2B is a perspective view of the laminate obtained in Step B1.
Fig. 3 is a schematic view describing Step C1 according to the first embodiment of the method of manufacturing the conductive laminate according to the present invention.
Fig. 4A is a partial sectional view of the laminate obtained through Steps E1 and D1 according to the first embodiment of the method of manufacturing the conductive laminate.
Fig. 4B is a perspective view of the laminate obtained through Steps E1 and D1.
Fig. 5A is a schematic view for describing a first deformation example of the first embodiment of the method of manufacturing the conductive laminate according to the present invention, and a partial sectional view of the laminate obtained in Step A2 in the deformation example of the first embodiment.
Fig. 5B is a schematic view for describing the first deformation example of the first embodiment of the method of manufacturing the conductive laminate according to the present invention and a top view of the laminate obtained in Step A2.
Fig. 5C is a schematic view for describing the first deformation example of the first embodiment of the method of manufacturing the conductive laminate according to the present invention and a partial sectional view of the laminate obtained in Step B2.
Fig. 6A is a schematic view for describing a second deformation example of the first embodiment of the method of manufacturing the conductive laminate according to the present invention, and a perspective view of the obtained conductive laminate.
Fig. 6B is a schematic view for describing the second deformation example of the first embodiment of the method of manufacturing the conductive laminate according to the present invention, and a cross-sectional view of the obtained conductive laminate.
Fig. 7A is a top view schematically illustrating a plated layer precursor layer-attached substrate 34 manufactured in Example 1 or 7 and a plated layer-attached substrate 44 manufactured in Example 2, 3, 8, or 9.
Fig. 7B is a partially enlarged view of Fig. 7A.
Fig. 8 is a top view schematically illustrating the plated layer precursor layer-attached substrate 34 manufactured in Example 4 and the plated layer-attached substrate 44 manufactured in Example 5, 6, or 10.

### DESCRIPTION OF THE PREFERRED EMBODIMENTS

Hereinafter, a method of manufacturing a conductive laminate according to the present invention, a conductive laminate, and a touch sensor are described. A plated layer precursor layer-attached substrate and a plated layer-attached substrate that can be used in the method of manufacturing the conductive laminate according to the present invention are described.

In the present specification, a numerical range using "to" means a range including numerical values before and after "to" as a lower limit and an upper limit. Drawings in the present invention are schematic views for easier understanding of the invention, and relations of thicknesses and positions of respective layers and the like are not identical to those in practice.

One of the features of the method of manufacturing a conductive laminate according to the present invention is that a substrate having a plated layer precursor layer or plated layer is deformed to a desired three-dimensional shape, a three-dimensional shape including a curved surface is formed, a plating treatment is performed, and a pattern-shaped metal layer is formed.

Generally, a metal layer formed by a metal plating treatment or a metal vapor deposition has excellent conductivity characteristics but has a low elongation at break compared with the organic conductive material. Therefore, in a case where the substrate is deformed in order to apply a three-dimensional shape including a curved surface after the metal layer is provided on the substrate, the metal layer does not follow the elongation of the substrate and is broken in many cases. Even though the metal layer does not break, the metal layer follows the substrate and elongate in a case of deformation, the film thickness becomes thin, and the resistance value tends to increase.

According to the shape of the formed product, the thickness of the metal layer becomes uneven due to uneven elongation in a case of deformation, there is a problem in that the variation in the resistance value easily occurs (for example, in a case where a hemispherical shaped formed product is formed, as it comes closer to the center of curvature, an elongation amount of the metal layer becomes large, such that thickness variation easily occurs and variation in resistance values occurs between metal layers).

In contrast, as described above, in a case where a plated layer precursor layer or a plated layer disposed on a substrate is deformed to a desired three-dimensional shape, the plated layer precursor layer or the plated layer can be deformed to follow the deformation of the substrate. Therefore, in a case where the plated layer precursor layer or the plated layer is formed on the substrate such that the plated layer precursor layer or the plated layer is disposed at a predetermined position on the substrate after deformation and the plating treatment is performed after the deformation of the substrate, the metal layer can be disposed at a predetermined position. For example, in a case where the plated layer precursor layer is used, in a step in which a pattern-shaped plated layer precursor layer in an unexposed (uncured) state is formed in an area in which a metal layer is to be formed on the substrate, this pattern-shaped plated layer precursor layer-attached substrate is deformed into a desired shape, and a three-dimensional shape including a curved surface is formed. Thereafter, the pattern-shaped plated layer precursor that is deformed to follow the substrate is cured by applying energy. In the following plating treatment, a metal layer is formed on the pattern-shaped plated layer which is a plating receiving layer (attached body), and a desired metal wiring pattern can be formed. That is, the shape of the pattern constituted by the pattern-shaped plated layer is substantially the same as the shape of the desired metal layer pattern.

As described above, the present invention does not have a step of deforming a metal layer, it is possible to manufacture a conductive laminate of which the resistance value is low, in which the variation of the resistance value is suppressed, and which has a three-dimensional shape including a curved surface.

Hereinafter, with reference to the drawings, the method of manufacturing the conductive laminate and the conductive laminate according to the present invention are described together with respective steps in the manufacturing method.

### <<First embodiment>>

Hereinafter, a first embodiment of the method of manufacturing the conductive laminate according to the present invention is described.

The first embodiment of the method of manufacturing the conductive laminate according to the invention includes a step (Step A1) of forming pattern-shaped plated layer precursor layers (hereinafter, also referred to as "patterned plated layer precursor layers") having a functional group of interacting a plating catalyst and a precursor thereof and a polymerizable group on one main surface of a substrate and obtaining a plated layer precursor layer-attached substrate, a step (Step B1) of forming a plated layer precursor layer-attached substrate in a three-dimensional shape including a curved surface, a step (Step C1) of applying energy to a patterned plated layer precursor and forming a pattern-shaped plated layer (hereinafter, also referred to as a "patterned plated layer"), a step (Step D1) of performing a plating treatment and forming a pattern-shaped metal layer (hereinafter, also referred to as a "patterned metal layer") on a patterned plated layer, and a step (Step E1) of applying a plating catalyst or a precursor thereof to a patterned plated layer after Step C1 and before Step D1.

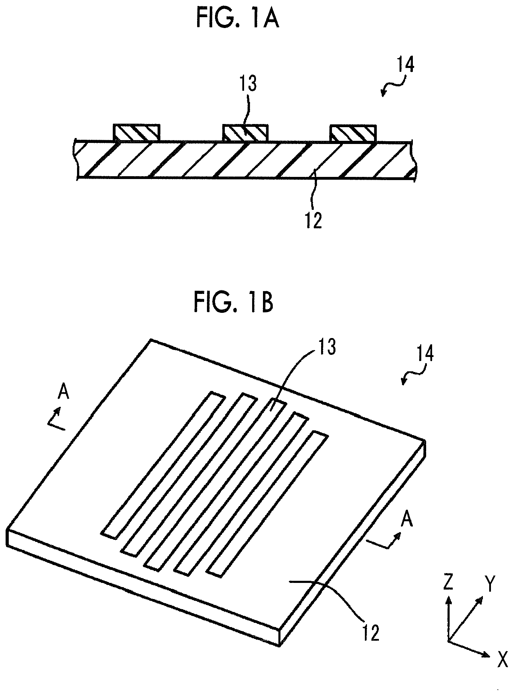

Each of the steps of the first embodiment and materials used in each of the steps is respectively described with reference to Figs. 1A to ID, 2A, 2B, 3, 4A, and 4B.

### [Step A1: Step of obtaining plated layer precursor layer-attached substrate]

Step A1 is a step of forming patterned plated layer precursor layers. Hereinafter, an aspect of the step, a step of forming patterned plated layer precursor layers on a substrate by using a plated layer forming composition including a compound of having a functional group (hereinafter, also referred to as an "interacting group") interacting with a plating catalyst or a precursor thereof or a composition (hereinafter, referred to as "Compound X" and "Composition Y") including the compound, and a step of obtaining a plated layer precursor layer-attached substrate.

In Figs. 1A to ID, schematic views describing Step A1 are illustrated. Fig. 1B is a perspective view of a plated layer precursor layer-attached substrate 14 formed in Step A1, and Fig. 1A is a partial sectional view of the A-A cross section thereof.

Specifically, as illustrated in Figs. 1A to ID, Step A1 is a step of forming patterned plated layer precursor layers 13 with a plated layer forming composition on a flat substrate 12 and obtaining the plated layer precursor layer-attached substrate 14. As illustrated in Fig. 1B, the plurality of patterned plated layer precursor layers 13 are disposed so as to project in a Y direction and having a predetermined interval in an X direction.

That is, the plated layer precursor layer-attached substrate obtained in Step A1 has a substrate and pattern-shaped plated layer precursor layers that are at least disposed at a position at which a curved surface is formed on a substrate in Step D1 described below and that have a functional group interacting with a plating catalyst or a precursor thereof and a polymerizable group.

A thickness of the patterned plated layer precursor layer 13 is preferably 10 to 5,000 nm and more preferably 100 to 2,000 nm.

According to the present invention, in view of formability, elongations at break of both of the substrate 12 and the plated layer precursor layer 13 at 200°C are preferably 50% or greater and more preferably 100% or greater. According to the present invention, the substrate 12 or the plated layer precursor layer 13 which does not break at 200°C and which cannot be measured such that a melting point is lower than 200°C can be used in this manner.

Here, the elongation at break of the substrate 12 or the patterned plated layer precursor layer 13 at 200°C refers to an elongation percentage in a case where, while a test piece for measuring an elongation at break which is formed such that the substrate 12 or the patterned plated layer precursor layer 13 is 150 mm×10 mm (film thickness: 100 µm) is heated to 200°C, a tensile test is conducted with a chuck distance of 100 mm and a tensile rate of 20 mm/min, and the substrate 12 or the patterned plated layer precursor layer 13 is broken.

The elongation at break of the patterned plated layer precursor layers 13 can be adjusted by materials of a resin and a solvent and a quantity ratio thereof.

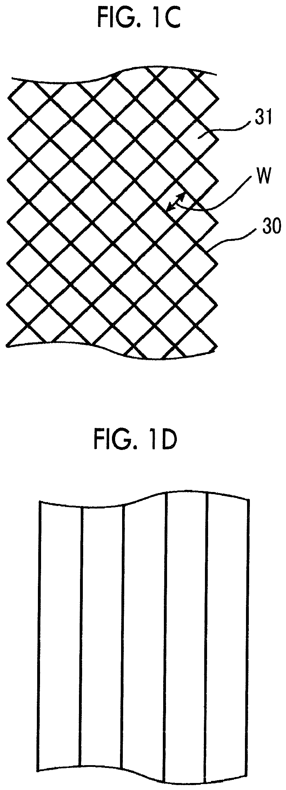

Fig. 1C is a partially enlarged plan view of the patterned plated layer precursor layer 13, and the patterned plated layer precursor layer 13 includes a plurality of thin lines 30 and has a mesh pattern including the plurality of lattices 31 by the intersecting thin lines 30.

A line width of the thin line 30 is not particularly limited. However, in view of comparatively easily forming a pattern shape according to a printing method, the line width thereof is preferably 1,000 µm or less, more preferably 500 µm or less, and even more preferably 300 µm or less, and preferably 2 µm or greater and more preferably 10 µm or greater.

The thickness of the thin line 30 is not particularly limited. However, in view of conductivity, the thickness thereof can be selected from 0.00001 to 0.2 mm, but the thickness is preferably 30 µm or less, more preferably 20 µm or less, even more preferably 0.01 to 9 µm, and most preferably 0.05 to 5 µm.

The lattices 31 include opening areas surrounded by the thin lines 30. A length W of one side of the lattices 31 is preferably 1,500 µm or less, more preferably 1,300 µm or less, even more preferably 1,000 µm or less, and preferably 5 µm or greater, more preferably 30 µm or greater, and even more preferably 80 µm or greater.

In a case where the patterned plated layer precursor layers 13 have the mesh pattern as described above, the metal layer is disposed on a plated layer formed by the patterned plated layer precursor layers 13, and thus the metal layer also has the same mesh pattern. In the metal layer formed in such a pattern, it is possible to obtain homogeneous metal characteristics in addition to the elongation percentage of the plated layer, and the obtained conductive laminate can be suitably used in the so-called touch panel sensor.

In Fig. 1C, the lattices 31 have a substantially diamond shape. However, in addition, it may be a polygon (for example, triangle, quadrangle, hexagon, or random polygon). In addition to a linear shape, the shape of one side may be a curved shape or an arc shape. In the case of an arc shape, for example, two opposing sides may be outwardly convex arc shape and the other two opposite sides may have an inwardly convex arc shape. The shape of each side may be a wavy line shape in which outwardly convex arc shapes and inwardly convex arc shapes are continuous. It is obvious that the shape of each side may be a sine curve.

In Fig. 1C, the patterned plated layer precursor layer 13 has a mesh pattern, but the shape thereof is not limited thereto and may be a stripe pattern as illustrated in Fig. 1D.

The method of applying the plated layer forming composition to the substrate 12 in a pattern shape is not particularly limited, and for example, a well-known method such as screen printing, inkjet printing, gravure printing, relief printing, intaglio printing, or reverse printing can be used. However, in view of being capable of forming a thick film, screen printing is preferable.

In addition to the method described above, a solid film of the plated layer precursor layer may be formed on the substrate 12, and unnecessary portions thereof may be removed to provide a pattern.

In view of easiness of handling or production efficiency, in a case where the substrate 12 is coated with the plated layer forming composition in a pattern shape and/or after the coating is performed, it is preferable that a drying treatment is performed, if necessary, such that a residual solvent is removed and a coating film is formed. The condition of the drying treatment is not particularly limited. However, in view of excellent productivity, the drying treatment is preferably performed at room temperature to 220°C (preferably 50 to 120°C) for 1 to 30 minutes (preferably 1 to 10 minutes).

### <Substrate 12>

The substrate 12 has two main surfaces, and can be formed in a three-dimensional shape including a curved surface and the types thereof is not particularly limited, as long as the substrate 12 supports patterned plated layers 15 described below. As the substrate, a substrate (preferably insulating substrate) having flexibility is preferable, and a resin substrate and the like can be used.

Examples of the resin substrate include a polyethersulfone-based resin, a polyacrylic resin, a polyurethane-based resin, a polyester-based resin (polyethylene terephthalate, polyethylene naphthalate, or the like), a polycarbonate-based resin, a polysulfone-based resin, a polyamide-based resin, a polyarylate-based resin, a polyolefin-based resin, a cellulose-based resin, a polyvinyl chloride-based resin, or a cycloolefin-based resin. Among these, a thermoplastic resin is preferable, and polyethylene terephthalate, polymethylmethacrylate (PMMA), polycarbonate, and a polyolefin-based resin are more preferable.

The thickness (mm) of the substrate is not particularly limited. However, in view of balance of easiness of handling and thinning, the thickness is preferably 0.05 to 2 mm and more preferably 0.1 to 1 mm.

With respect to the substrate, at least a portion thereof may have a multilayer structure, and, for example, may include a functional film as one layer thereof. In addition, the substrate itself may be a functional film.

The functional film is not particularly limited, but examples thereof include a polarizing plate, a phase difference film, cover plastic, a hard coat film, a barrier film, a pressure sensitive adhesive film, an electromagnetic wave shielding film, a heat generating film, an antenna film, or a wiring film for devices other than the touch panel.

A liquid crystal cell can be partially introduced into the substrate, and as specific examples of the functional film, a NPF series (manufactured by Nitto Denko Corporation) or a HLC2 series (manufactured by Sanritz Corporation) may be used as a polarizing plate, a WV film (manufactured by FUJIFILM Corporation) may be used as a phase difference film, FAINDE (manufactured by Dai Nippon Printing Co., Ltd.), TECHNOLLOY (manufactured by Sumitomo Chemical Co., Ltd.), Iupilon (manufactured by Mitsubishi Gas Chemical Company), SILPLUS (manufactured by Nippon Steel & Sumitomo Metal Corporation), ORGA (manufactured by Nippon Synthetic Chem Industry Co., Ltd.), or SHORAYAL (Showa Denko K. K.) may be used as a cover plastic, and an H series (manufactured by Lintec Corporation), an FHC series (manufactured by Higashiyama Film Co., Ltd.) or a KB film (manufactured by KIMOTO Co., Ltd.) may be used as the hard coat film. These may be bonded to the substrate 12.

With respect to the polarizing plate or a phase difference film, cellulose triacetate may be used as disclosed in JP2007-26426A. However, in view of resistance to a plating process, cellulose triacetate may be changed to a cycloolefin (co)polymer to be used, and examples thereof include ZEONOR (manufactured by Zeon Corporation).

### <Plated layer forming composition>

Hereinafter, components included in the plated layer forming composition and components that may be contained are described.

The plated layer forming composition contains Compound X or Composition Y below.
Compound X: A compound having a functional group (hereinafter, simply referred to as an "interacting group") that interacts with a plating catalyst or a precursor thereof and a polymerizable group
Composition Y: A composition including a compound having a functional group that interacts with a plating catalyst or a precursor thereof and a compound having a polymerizable group

### (Compound X)

Compound X is a compound having an interacting group and a polymerizable group.

The interacting group means a functional group that can interact with a plating catalyst applied to the patterned plated layers 15 or a precursor thereof. For example, a functional group that can form electrostatic interaction with a plating catalyst or a precursor thereof, or a nitrogen-containing functional group, a sulfur-containing functional group, and an oxygen-containing functional group that can perform coordination formation with a plating catalyst or a precursor thereof can be used.

Specific examples of the interacting group include a nitrogen-containing functional group such as an amino group, an amide group, an imide group, a urea group, a tertiary amino group, an ammonium group, an amidino group, a triazine ring, a triazole ring, a benzotriazole group, an imidazole group, a benzimidazole group, a quinoline group, a pyridine group, a pyrimidine group, a pyrazine group, a nazoline group, a quinoxaline group, a purine group, a triazine group, a piperidine group, a piperazine group, a pyrrolidine group, a pyrazole group, an aniline group, a group containing an alkylamine structure, a group containing an isocyanuric structure, a nitro group, a nitroso group, an azo group, a diazo group, an azide group, a cyano group, or, a cyanate group; an oxygen-containing functional group such as an ether group, a hydroxyl group, a phenolic hydroxyl group, a carboxylic acid group, a carbonate group, a carbonyl group, an ester group, a group containing an N-oxide structure, a group containing an S-oxide structure, or a group containing an N-hydroxy structure; a sulfur-containing functional group such as a thiophene group, a thiol group, a thiourea group, a thiocyanuric acid group, a benzthiazole group, a mercaptotriazine group, a thioether group, a thioxy group, a sulfoxide group, a sulfone group, a sulfite group, a group containing a sulfoximine structure, a group containing a sulfoxinium salt structure, a sulfonic acid group, or a group containing a sulfonic acid ester structure; a phosphorus-containing functional group such as a phosphate group, a phosphoramido group, a phosphine group, or a group containing a phosphoric acid ester structure; and a group containing a halogen atom such as a chlorine atom or a bromine atom, and in the case of a functional group having a salt structure, salts thereof can also be used.

Among these, since polarity is high and adsorption ability to a plating catalyst or a precursor thereof is high, an ionic polar group such as a carboxylic acid group, a sulfonic acid group, a phosphate group, or a boronic acid group, an ether group, or a cyano group is particularly preferable, and a carboxylic acid group (a carboxyl group) or a cyano group is even more preferable.

Two or more kinds of interacting groups may be included in Compound X.

The polymerizable group is a functional group that can form a chemical bond by applying energy, and examples thereof include a radically polymerizable group or a cationically polymerizable group. Among these, in view of excellent reactivity, a radically polymerizable group is preferable. Examples of the radically polymerizable group include an unsaturated carboxylic acid ester group such as an acrylic acid ester group (acryloyloxy group), a methacrylic acid ester group (methacryloyloxy group), an itaconic acid ester group, a crotonic acid ester group, an isocrotonic acid ester group, or a maleic acid ester group, a styryl group, a vinyl group, an acrylamide group, or a methacrylamide group. Among these, a methacryloyloxy group, an acryloyloxy group, a vinyl group, a styryl group, an acrylamide group, or a methacrylamide group is preferable, and a methacryloyloxy group, an acryloyloxy group, or a styryl group is more preferable.

Two or more kinds of polymerizable groups may be included in Compound X. The number of polymerizable groups included in Compound X is not particularly limited, and may be one or may be two or more.

Compound X may be a low molecular weight compound or may be a high molecular weight compound. The low molecular weight compound means a compound having a molecular weight of less than 1,000, and the high molecular weight compound means a compound having a molecular weight of 1,000 or greater.

The low molecular weight compound having the polymerizable group corresponds to a so-called monomer. The high molecular weight compound may be a polymer having a predetermined repeating unit.

The compound may be used singly or two or more kinds thereof may be used in combination.

In a case where Compound X is a polymer, a weight-average molecular weight of the polymer is not particularly limited. In view of solubility and excellent handleability, the weight-average molecular weight is preferably 1,000 to 700,000 and even more preferably 2,000 to 200,000. Particularly, in view of polymerization sensitivity, the weight-average molecular weight is preferably 20,000 or greater.

The method of synthesizing the polymer having a polymerizable group and an interacting group is not particularly limited, and a well-known synthesis method (see paragraphs [0097] to [0125] of JP2009-280905A) is used.

### (Suitable Aspect 1 of polymer)

Examples of a first preferable aspect of the polymer include a copolymer including a repeating unit (hereinafter, suitably also referred to as a polymerizable group unit) having a polymerizable group represented by Formula (a) and a repeating unit (hereinafter, suitably also referred to as an interacting group unit) having an interacting group represented by Formula (b).

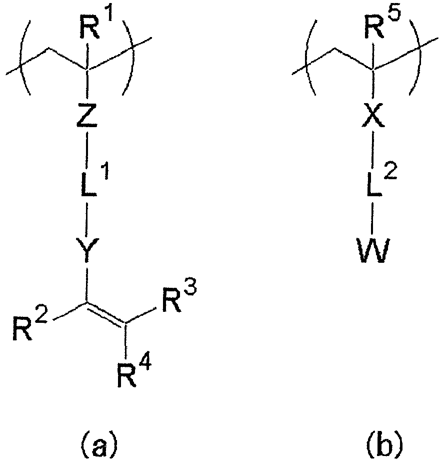

In Formulae (a) and (b), R¹ to R⁵ each independently represent a hydrogen atom, or a substituted or unsubstituted alkyl group (for example, a methyl group, an ethyl group, a propyl group, or a butyl group). The kind of the substituent is not particularly limited, but examples thereof include a methoxy group, a chlorine atom, a bromine atom, or a fluorine atom.

R¹ is preferably a hydrogen atom, a methyl group, or a methyl group substituted with a bromine atom. R² is preferably a hydrogen atom, a methyl group, or a methyl group substituted with a bromine atom. R³ is preferably a hydrogen atom. R⁴ is preferably a hydrogen atom. R⁵ is preferably a hydrogen atom, a methyl group, or a methyl group substituted with a bromine atom.

In Formulae (a) and (b), X, Y, and Z each independently represent a single bond or a substituted or unsubstituted divalent organic group. Examples of the divalent organic group include a substituted or unsubstituted divalent aliphatic hydrocarbon group (preferably having 1 to 8 carbon atoms, for example, an alkylene group such as a methylene group, an ethylene group, or a propylene group), a substituted or unsubstituted divalent aromatic hydrocarbon group (preferably having 6 to 12 carbon atoms, for example, a phenylene group), -O-, -S-, -SO₂-, -N(R)- (R: alkyl group), -CO-, -NH-, -COO-, -CONH-, or a group obtained by combining these (for example, an alkyleneoxy group, an alkyleneoxycarbonyl group, or an alkylene carbonyloxy group).

Since a polymer is easily synthesized, and adhesiveness of patterned metal layers 18 is excellent, X, Y, and Z are preferably a single bond, an ester group (-COO-), an amide group (-CONH-), an ether group (-O-), or a substituted or unsubstituted divalent aromatic hydrocarbon group, and more preferably a single bond, an ester group (-COO-), or an amide group (-CONH-).

In Formulae (a) and (b), L¹ and L² each independently represent a single bond or a substituted or unsubstituted divalent organic group. The definition of the divalent organic group is the same meaning as the divalent organic group described above in X, Y, and Z.

Since a polymer is easily synthesized, and adhesiveness of the patterned metal layers 18 is excellent, L¹ is preferably an aliphatic hydrocarbon group or a divalent organic group (for example, an aliphatic hydrocarbon group) having a urethane bond or a urea bond. Among these, a group of which the total number of carbon atoms is 1 to 9 is preferable. Here, the total number of carbon atoms of L¹ means a total number of carbon atoms included in the substituted or unsubstituted divalent organic group represented by L¹.

Since adhesiveness of the patterned metal layers 18 is excellent, L² is preferably a single bond, a divalent aliphatic hydrocarbon group, a divalent aromatic hydrocarbon group, or a group obtained by combining these. Among these, L² is preferably a single bond, or a group of which the total number of carbon atoms is 1 to 15, and particularly preferably unsubstituted. Here, the total number of carbon atoms of L² means the total number of carbon atoms included in a substituted or unsubstituted divalent organic group represented by L².

In Formula (b), W represents an interacting group. The definition of the interacting group is as described above.

In view of reactivity (curability and polymerizability) and suppression of gelation in a case of synthesis, the content of the polymerizable group unit is preferably 5 to 50 mol% and more preferably 5 to 40 mol% with respect to the entire repeating unit of the polymer.

In view of absorptivity to a plating catalyst or a precursor thereof, the content of the interacting group unit is preferably 5 to 95 mol% and more preferably 10 to 95 mol% with respect to the entire repeating unit in the polymer.

### (Suitable Aspect 2 of polymer)

A second preferable aspect of the polymer includes a copolymer including repeating units represented by Formulae (A), (B), and (C).

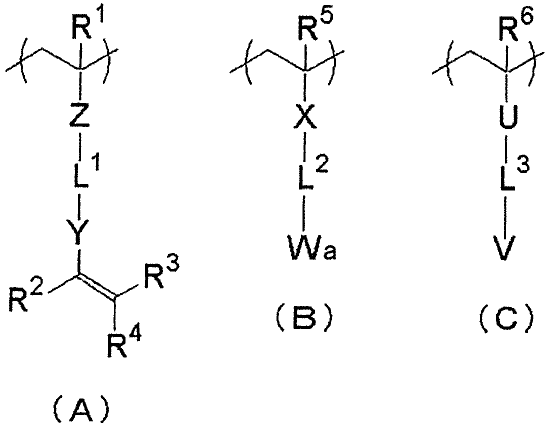

The repeating unit represented by Formula (A) is the same as the repeating unit represented by Formula (a), and descriptions of the respective groups are the same.

R⁵, X, and L² in the repeating unit represented by Formula (B) are the same as R⁵, X, and L² in the repeating unit represented by Formula (b), and descriptions of the respective groups are the same.

Wa in Formula (B) represents a group interacting with a plating catalyst or a precursor thereof, except for a hydrophilic group represented by V described below and a precursor group thereof. Among these, a cyano group or an ether group is preferable.

In Formula (C), R⁶ each independently represent a hydrogen atom, or a substituted or unsubstituted alkyl group.

In Formula (C), U represents a single bond or a substituted or unsubstituted divalent organic group. The definition of the divalent organic group has the same meaning as the divalent organic group represented by X, Y, and Z described above. Since the polymer is easily synthesized and adhesiveness of the patterned metal layers 18 is excellent, U is preferably a single bond, an ester group (-COO-), an amide group (-CONH-), an ether group (-O-), or a substituted or unsubstituted divalent aromatic hydrocarbon group.

In Formula (C), L³ represents a single bond or a substituted or unsubstituted divalent organic group. The definition of the divalent organic group is the same as that of the divalent organic group represented by L¹ and L² described above. Since the polymer is easily synthesized and adhesiveness of the patterned metal layers 18 is excellent, L³ is preferably a single bond or a divalent aliphatic hydrocarbon group, a divalent aromatic hydrocarbon group, or a group obtained by combining these.

In Formula (C), V represents a hydrophilic group or a precursor group thereof. The hydrophilic group is not particularly limited, as long as the hydrophilic group exhibits hydrophilicity. Examples thereof include a hydroxyl group or a carboxylic acid group. The precursor group of the hydrophilic group means a group that generates a hydrophilic group by a predetermined treatment (for example, a treatment by acid or alkali), and examples thereof include a carboxyl group protected by THP (2-tetrahydropyranyl group).

In view of interaction with a plating catalyst or a precursor thereof, the hydrophilic group is preferably an ionic polar group. Specific examples of the ionic polar group include a carboxylic acid group, a sulfonic acid group, a phosphoric acid group, or a boronic acid group. Among these, in view of moderate acidity (that does not decompose other functional groups), a carboxylic acid group is preferable.

A preferable content of respective units in the second preferable aspect of the polymer is as described below.

In view of reactivity (curability and polymerizability) and suppression of gelation in a case of synthesis, the content of the repeating unit represented by Formula (A) is preferably 5 to 50 mol% and more preferably 5 to 30 mol% with respect to the entire repeating unit of the polymer.

In view of absorptivity to a plating catalyst or a precursor thereof, the content of the repeating unit represented by Formula (B) is preferably 5 to 75 mol% and more preferably 10 to 70 mol% with respect to the entire repeating unit of the polymer.

In view of developability of an aqueous solution and moisture resistance adhesiveness, the content of the repeating unit represented by Formula (C) is preferably 10 to 70 mol%, more preferably 20 to 60 mol%, and even more preferably 30 to 50 mol% with respect to the entire repeating unit in the polymer.

Specific examples of the polymer include polymers disclosed in paragraphs [0106] to [0112] of JP2009-007540A, polymers disclosed in paragraphs [0065] to [0070] in JP2006-135271A, or polymers disclosed in paragraphs [0030] to [0108] of US2010-080964A.

This polymer can be manufactured by the well-known method (for example, methods in the documents exemplified above).

### (Suitable Aspect of monomer)

In a case where the compound is a so-called monomer, one of the suitable aspects includes a compound represented by Formula (X).

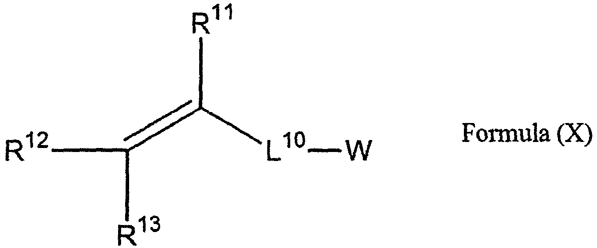

In Formula (X), R¹¹ to R¹³ each independently represent a hydrogen atom, or a substituted or unsubstituted alkyl group. Examples of the unsubstituted alkyl group include a methyl group, an ethyl group, a propyl group, or a butyl group. Examples of the substituted alkyl group include a methoxy group, or a methyl group, an ethyl group, a propyl group, or a butyl group which is substituted with a chlorine atom, a bromine atom, a fluorine atom, or the like. As R¹¹, a hydrogen atom or a methyl group is preferable. As R¹², a hydrogen atom is preferable. As R¹³, a hydrogen atom is preferable.

L¹⁰ represents a single bond or a divalent organic group. Examples of the divalent organic group include a substituted or unsubstituted aliphatic hydrocarbon group (preferably having 1 to 8 carbon atoms), a substituted or unsubstituted aromatic hydrocarbon group (preferably having 6 to 12 carbon atoms), -O-, -S-, -SO₂-, -N(R)- (R: alkyl group), -CO-, -NH-, -COO-, -CONH-, or a group obtained by combining these (for example, an alkyleneoxy group, an alkyleneoxycarbonyl group, and an alkylene carbonyloxy group).

The substituted or unsubstituted aliphatic hydrocarbon group is preferably a methylene group, an ethylene group, a propylene group, a butylene group, or a group obtained by substituting these groups with a methoxy group, a chlorine atom, a bromine atom, a fluorine atom, or the like.

The substituted or unsubstituted aromatic hydrocarbon group is preferably an unsubstituted phenylene group or a phenylene group substituted with a methoxy group, a chlorine atom, a bromine atom, a fluorine atom, or the like.

In Formula (X), one of the suitable aspects of L¹⁰ includes a -NH- aliphatic hydrocarbon group- or a -CO- aliphatic hydrocarbon group-.

The definition of W is the same as the definition of W in Formula (b), and W represents an interacting group. The definition of the interacting group is as described above.

In Formula (X), a suitable aspect of W includes an ionic polar group, and a carboxylic acid group is more preferable.

### (Composition Y)

Composition Y is a composition including a compound having an interacting group and a compound having a polymerizable group. That is, the plated layer precursor layer includes two kinds of a compound having an interacting group and a compound having a polymerizable group. The definitions of the interacting group and the polymerizable group are as described above.

The compound having an interacting group is a compound having an interacting group. The definition of the interacting group is as described above. The compound may be a low molecular weight compound or may be a high molecular weight compound. The suitable aspect of the compound having an interacting group include a polymer (for example, a polyacrylic acid) having a repeating unit represented by Formula (b). A polymerizable group is not included in the compound having an interacting group.

The compound having a polymerizable group is a so-called monomer. Since the hardness of the formed patterned plated layers 15 becomes excellent, the compound is preferably a polyfunctional monomer having two or more polymerizable groups. Specifically, in the polyfunctional monomer, a monomer having two to six polymerizable groups is preferably used. In view of the mobility of molecules in the crosslinking reaction that have an influence on reactivity, the molecular weight of the used polyfunctional monomer is preferably 150 to 1,000 and more preferably 200 to 800. The interval (distance) between a plurality of existing polymerizable groups is preferably 1 to 15.

An interacting group may be included in the compound having a polymerizable group.

One of the suitable aspects of the compound having a polymerizable group includes a compound represented by Formula (1) below.

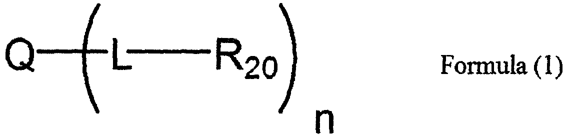

In Formula (1), R₂₀ represents a polymerizable group.

L represents a single bond or a divalent organic group. The definition of the divalent organic group is as described above.

Q represents an n-valent organic group. Preferable examples of the n-valent organic group include a group represented by Formula (1A) and a group represented by Formula (1B),

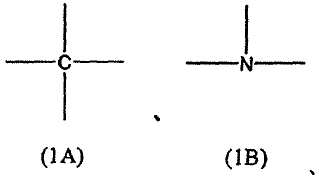

-NH-, -NR (R: alkyl group)-, -O-, -S-, a carbonyl group, an alkylene group, an alkenylene group, an alkynylene group, a cycloalkylene group, an aromatic group, a heterocyclic group, and an n-valent organic group consisting of two or more kinds of these in combination.

n represents an integer of 2 or greater and is preferably 2 to 6.

Among the polyfunctional monomers, the hardness of the formed patterned plated layers 15 is more excellent, polyfunctional (meth)acrylamide is preferably used.

Polyfunctional (meth)acrylamide is not particularly limited as long as a group has two or more (preferably two to six) (meth)acrylamide groups.

Among polyfunctional (meth)acrylamide, since the curing speed of the patterned plated layer precursor layer 13 is excellent, methylene bisacrylamide or tetrafunctional (meth)acrylamide represented by Formula (A) can be more preferably used.

According to the present invention, (meth)acrylamide is a concept of including acrylamide and methacrylamide.

Examples of tetrafunctional (meth)acrylamide represented by Formula (A) can be manufactured by a manufacturing method disclosed in JP5486536B.

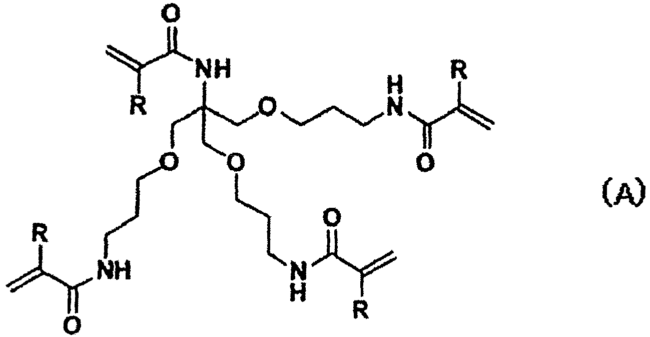

In Formula (A), R represents a hydrogen atom or a methyl group. In Formula (A), a plurality of R's may be identical to or different from each other.

A mass ratio (a mass of the compound having an interacting group/a mass of the compound having a polymerizable group) of a compound having an interacting group and a compound having a polymerizable group is not particularly limited. However, in view of balance between strength and plating suitability of the formed patterned plated layers 15, the mass ratio is preferably 0.1 to 10 and more preferably 0.5 to 5.

The content of Compound X (or Composition Y) in the patterned plated layer precursor layer 13 is not particularly limited but is preferably 50 mass% or greater and more preferably 80 mass% or greater with respect to 100 mass% of the total solid content in the plated layer forming composition. The upper limit thereof is not particularly limited, but is preferably 99.5 mass% or less.

Other components in addition to Compound X and Composition Y may be included in the patterned plated layer precursor layer 13.

A polymerization initiator may be included in the patterned plated layer precursor layer 13. In a case where the polymerization initiator is included, the reaction between the polymerizable groups in a case of an exposure treatment more effectively proceeds.

The polymerization initiator is not particularly limited, and a well-known polymerization initiator (so-called photopolymerization initiator) and the like can be used. Examples of the polymerization initiator include benzophenones, acetophenones, α-aminoalkylphenones, benzoins, ketones, thioxanthones, benzyls, benzyl ketals, oxime esters, antholones, tetramethyl thiuram monosulfides, bisacylphosphinooxides, acylphosphine oxides, anthraquinones, azo compounds, and derivatives thereof.

The content of the polymerization initiator in the patterned plated layer precursor layer 13 is not particularly limited. However, in view of curability of the patterned plated layers 15, the content is preferably 0.01 to 1 mass% and more preferably 0.1 to 0.5 mass% with respect to 100 mass% of the total solid content of the plated layer forming composition.

Other additives (for example, an organic solvent, a sensitizer, a curing agent, a polymerization inhibitor, an antioxidant, an antistatic agent, a filler, particles, a flame retardant, a lubricant, or a plasticizer) may be added to the patterned plated layer precursor layer 13, if necessary.

Particularly, in a case where an organic solvent is contained, since a function of the silicone surfactant or the fluorine surfactant among the above surfactants is further exhibited, a hydrophilic solvent such as isopropanol or propylene glycol-1-monomethyl ether-2-acetate is preferable.

### [Step B1: Step of forming three-dimensional shape including curved surface]

Step B1 is a step of deforming (bending) a plated layer precursor layer-attached substrate such that at least a portion of the plated layer precursor layer is deformed and forming the plated layer precursor layer-attached substrate in a desired three-dimensional shape including a curved surface. In other words, the plated layer precursor layer-attached substrate is deformed such that a portion in which a plated layer precursor layer and a substrate are laminated is deformed (curved), and the desired three-dimensional shape including the curved surface is applied to the plated layer precursor layer and the substrate. After the present step, it is possible to obtain the plated layer precursor layer-attached substrate having the plated layer precursor layer in which at least a portion of the surface is curved surface (in other words, a curved portion).

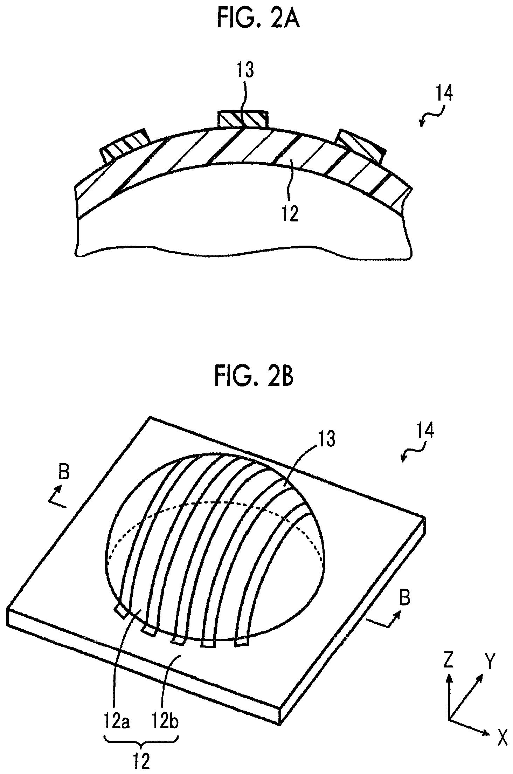

In Figs. 2A and 2B, schematic views describing Step B1 is illustrated. Fig. 2B is a perspective view of the plated layer precursor layer-attached substrate 14 forming in a hemispherical shape in Step B1, and Fig. 2A is a partial sectional view of the B-B cross section.

As understood from the comparison with Figs. 1B and 2B, in this step, the substrate 12 is deformed (curved) such that at least a portion of the patterned plated layer precursor layers 13 disposed on the substrate 12 is deformed (curved). Specifically, a portion (particularly, a central portion in which the patterned plated layer precursor layer 13 is disposed) of the flat substrate 12 is deformed to a hemispherical shape, and a hemisphere portion 12a is formed. According to this deformation, the substrate 12 has a three-dimensional shape having the hemisphere portion 12a and a flat portion 12b that spreads outside from a bottom surface of the hemisphere portion 12a.

At this point, the patterned plated layer precursor layers 13 also deform to follow the deformation of the substrate 12. That is, the patterned plated layer precursor layers 13 projecting in one direction (the Y direction illustrated in Fig. 1B) elongate in the direction projecting along the deformation of the substrate 12. As a result, as illustrated in Fig. 2B, the patterned plated layer precursor layers 13 are disposed to project in one direction without disconnection so as to follow the curved surface shape of the hemisphere portion 12a of the substrate 12.

In Figs. 2A and 2B, an aspect in which the substrate deforms to a hemispherical shape is illustrated. However, in a case where the substrate having a three-dimensional shape including a curved surface is formed, the present invention is not limited to this aspect. Examples of the three-dimensional shape including the curved surface include a Kamaboko shape, a wave shape, a roughness shape, a concave and convex shape, and a cylindrical shape.

In Figs. 2A and 2B, an aspect in which a portion of the plated layer precursor layer-attached substrate is deformed, and a three-dimensional shape including a curved surface is applied to the plated layer precursor layer-attached substrate is provided. However, the present invention is not limited to this aspect, and the entire plated layer precursor layer-attached substrate may be deformed.

The deforming method in Step B1 is not particularly limited, and a well-known method such as vacuum forming, blow forming, free blow forming, pressure forming, vacuum-pressure forming, or hot press forming can be used. The temperature of the heat treatment performed in a case of deformation is preferably a temperature greater than the heat deformation temperature of the material of the substrate 12 and is preferably in the range of the glass transition temperature (Tg)+50°C to 350°C. For example, the temperature of the heat treatment is 170°C to 270°C in a case of the PMMA resin and is about 250°C to 320°C in a case of polycarbonate.

In a case of forming, an annealing treatment for removing distortion remaining in the substrate 12 may be performed by performing preliminary heating.

The thickness of the patterned plated layer precursor layers 13 to which the three-dimensional shape is applied is preferably 10 to 5,000 nm and more preferably 100 to 2,000 nm.

### [Step C1: Step of forming patterned plated layer]

Step C1 is a step of applying energy to the plated layer precursor layer of the plated layer precursor layer-attached substrate having the tree-mensona shape including a curved surface manufactured in Step B1, curing the plated layer precursor layer, and forming a patterned plated layer.

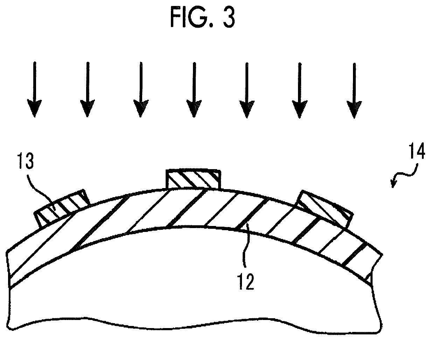

In Fig. 3, a cross section schematic view describing Step C1 is illustrated. Specifically, as illustrated in Fig. 3, Step C1 is a step of applying energy to the patterned plated layer precursor layers 13 as illustrated by black arrows, promoting the reaction with the polymerizable group, and curing the patterned plated layer precursor layers 13, and obtaining the patterned plated layers 15. The patterned plated layers 15 formed by Step C1 absorb (adhere) the plating catalyst or the precursor thereof in a case of Step E1 described below according to the function of the interacting group. That is, the patterned plated layers 15 function as a satisfactory receiving layer of the plating catalyst or the precursor thereof described above. The polymerizable group is used in the bonding between compounds by a cured treatment by energy application and the patterned plated layers 15 that have excellent strength·hardness can be obtained.

The method of applying energy to the patterned plated layer precursor layers 13 is not particularly limited. For example, a heating treatment or an exposure treatment (photoirradiation treatment) is preferably used, and since the treatment is completed for a short period of time, the exposure treatment is preferable. In a case where the energy is applied, the polymerizable group in the compound is activated, crosslinking between the compounds occur, and curing of the layers proceeds.

In the exposure treatment, light irradiation and the like due to an ultraviolet (UV) lamp, visible rays, and the like is used. Examples of the light source include a mercury lamp, a metal halide lamp, a xenon lamp, a chemical lamp, and a carbon arc lamp. Examples of the radiation include electron beams, X-rays, ion beams, and far infrared rays. Specific aspect thereof suitably includes scanning exposure by an infrared laser, high-intensity flash exposure such as a xenon discharge lamp, or infrared lamp exposure.

The exposure time varies according to the reactivity of the compound and the light source, but is generally 10 seconds to 5 hours. The exposure energy may be about 10 to 8,000 mJ/cm² and preferably in the range of 50 to 3,000 mJ/cm².

In a case where the heating treatment by energy application, an air dryer, an oven, an infrared dryer, or a heating drum may be used.

The thickness of the patterned plated layers 15 formed by the treatment is not particularly limited. However, in view of productivity, the thickness is preferably 0.01 to 10 µm, more preferably 0.05 to 5 µm, and particularly preferably 0.1 to 2.0 µm.

### [Step E1: Step of applying plating catalyst, Step D1: Step of forming patterned metal layer]

Step D1 is a step of performing a plating treatment to the patterned plated layer and forming a patterned metal layer on the patterned plated layer. In the first embodiment, before performing Step D1, Step E1 of applying the plating catalyst or the precursor thereof to the patterned plated layer formed in Step C1.

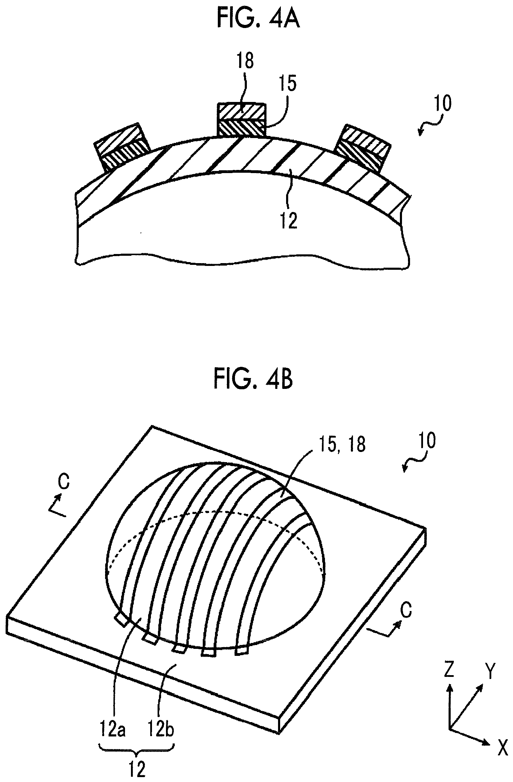

In Figs. 4A and 4B, schematic views describing Steps E1 and D1 are illustrated. Fig. 4B is a perspective view of a conductive laminate 10 obtained by laminating the pattern-shaped metal layers 18 in Steps E1 and D1, and Fig. 4A is a partial sectional view of the C-C cross section.

As illustrated in Fig. 4A, the conductive laminate 10 in which the patterned metal layers 18 are disposed on the patterned plated layers 15 can be obtained by applying the plating catalyst or the precursor thereof in Step E1 and by the metal plating treatment by Step D1.

In the conductive laminate 10 illustrated in Figs. 4A and 4B, the patterned metal layers 18 are formed only on the upper surface of the patterned plated layers 15, but the present invention is not limited and may be formed on the upper surface and side surface (that is, the entire surface of the patterned plated layers 15) of the patterned plated layers 15.

Hereinafter, first, a step (Step E1) of applying the plating catalyst or the precursor thereof to the patterned plated layers 15 and subsequently a step (Step D1) of performing a plating treatment to the patterned plated layers 15 to which the plating catalyst or the precursor thereof is applied is described.

### (Step El: Step of applying plating catalyst)

In this step, first, the plating catalyst or the precursor thereof is applied to the patterned plated layers 15. Since the interacting group is included in the patterned plated layers 15, the interacting group adheres (absorbs) the applied plating catalyst or the applied precursor thereof, according to the function thereof.

Specifically, the plating catalyst or the precursor is applied to the surfaces of the patterned plated layers 15.

The plating catalyst or the precursor thereof functions as a catalyst or an electrode of the plating treatment.

Therefore, the kinds of the used plating catalyst or the used precursor are suitably determined according to the kind of the plating treatment.

The used plating catalyst or the precursor thereof is preferably the electroless plating catalyst or the precursor thereof. Hereinafter, the electroless plating catalyst or the electroless precursor thereof is described above.

As the electroless plating catalyst used in this step, any electroless plating catalyst can be used as long as the electroless plating catalyst becomes an active nucleus in a case of electroless plating. Specific examples thereof include metal with catalytic ability for autocatalytic reduction reaction (those known as electroless plating metal with lower ionization tendency than Ni). Specific examples thereof include Pd, Ag, Cu, Ni, Pt, Au, or Co. Among these, in view of height of the catalytic ability, Ag, Pd, Pt, or Cu is particularly preferable.

As this electroless plating catalyst, metal colloid may be used.

The electroless plating catalyst precursor used in this step can be used without limitation, as long as the electroless plating catalyst precursor can be an electroless plating catalyst due to the chemical reaction. Mainly, metal ions of the metal exemplified as the electroless plating catalyst are used. The metal ions which are the electroless plating catalyst precursor become zero-valent metal which is an electroless plating catalyst due to reduction reaction. After the application to the patterned plated layers 15 and before the immersion in the electroless plating bath, the metal ion which is the electroless plating catalyst precursor may be changed to zero-valent metal by independent reduction reaction to be used as an electroless plating catalyst. The electroless plating catalyst precursor without change is immersed in an electroless plating bath and changed to metal (electroless plating catalyst) by the reducing agent in the electroless plating bath.

The metal ions which are the electroless plating catalyst precursor are preferably applied to the patterned plated layers 15 by using metal salt. The used metal salt is not particularly limited as long as the metal salt is dissolved in an appropriate solvent and dissociated into a metal ion and a base (anion), and examples thereof include M(NO₃)n, MCln, M_{2/n} (SO₄), or M_{3/n}(PO₄) (M represents an n-valent metal atom).

As the method of applying the plating catalyst or the precursor thereof to the patterned plated layers 15, for example, a solution obtained by dispersing or dissolving the plating catalyst or the precursor thereof in an appropriate solvent is prepared, and the patterned plated layers 15 may be coated with the solution or the laminate on which the patterned plated layers 15 are formed may be immersed in the solution.

As the solvent, water or an organic solvent is suitably used.

### (Step D1: Plating treatment step)

Subsequently, a plating treatment is performed on the patterned plated layers 15 to which the plating catalyst or the precursor thereof is applied.

The plating treatment method is not particularly limited, but examples thereof include an electroless plating treatment, or an electrolytic plating treatment (electric plating treatment). In this step, the electroless plating treatment may be singly performed or the electrolytic plating treatment may be performed after the electroless plating treatment is performed.

Hereinafter, the electroless plating treatment and the procedures of the electrolytic plating treatment are described.

The electroless plating treatment refers to an operation of precipitating metal by chemical reaction by using the solution obtained by dissolving metal ions desired to be precipitated as plating.

The electroless plating in this step is preferably performed by washing the laminate including the patterned plated layers 15 to which the electroless plating catalyst is applied with water and immersing the laminate in an electroless plating bath after the remaining electroless plating catalyst (metal) is removed. As the used electroless plating bath, a well-known electroless plating bath can be used.

In a case where the substrate 12 including the patterned plated layers 15 to which the electroless plating catalyst precursor is applied is immersed in the electroless plating bath in a state in which the electroless plating catalyst precursor is absorbed or impregnated in the patterned plated layers 15, it is preferable to immerse the laminate in an electroless plating bath after the laminate is washed with water and the remaining electroless plating catalyst precursor (metal salt and the like) is removed.

The reduction of the electroless plating catalyst precursor can be performed as an independent step before electroless plating by preparing a catalyst activated solution (reducing solution), independently from the aspect of using the electroless plating solution as described above.

As the composition of a general electroless plating bath, in addition to the solvent (for example, water), 1. metal ions for plating, 2. a reducing agent, and 3. an additive (stabilizer) that improves stability of metal ions are mainly included. In addition to the above, well-known additives such as a plating bath stabilizer may be included in this plating bath.

The organic solvent used in the electroless plating bath needs to be a solvent that can be used with water, and in this point of view, ketones such as acetone or alcohols such as methanol, ethanol or isopropanol is preferably used. As the kinds of the metal used in the electroless plating bath, copper, tin, lead, nickel, gold, silver, palladium, or rhodium is known. Among these, in view of conductivity, copper, silver, or gold is preferable, and copper is more preferable. A reducing agent and an additive that are optimal according to the metal are selected.

The immersion time in the electroless plating bath is preferably about one minute to six hours and more preferably one minute to three hours.

In this step, the plating catalyst applied to the patterned plated layers 15 and the precursor thereof have functions as the electrode, electric plating can be performed on the patterned plated layers 15 to which the catalyst or the precursor thereof is applied.

As described above, in this step, an electrolytic plating treatment can be performed after the electroless plating treatment, if necessary. In this aspect, the thickness of the formed patterned metal layers 18 can be suitably adjusted.

As illustrated in Figs. 4A and 4B, the conductive laminate 10 that is obtained by the first embodiment has each of the substrate 12 having a hemispherical shape, the patterned plated layers 15 on the circumference curved surface of the substrate 12, and the patterned metal layers 18 disposed on the patterned plated layers 15.

The conductive laminate 10 can be applied to the various uses as described below, and, for example, can be applied to a touch sensor. In a case where the conductive laminate 10 is applied to a touch sensor, the patterned metal layers 18 can be caused to function as a so-called sensor electrode, and lead-out wiring may be electrically connected to end portions of the patterned metal layers 18.

### [Arbitrary step]

In the method of manufacturing the conductive laminate according to the present invention, before Step A1 is performed, a step of providing a primer layer on a substrate may be performed. In a case where a primer layer is disposed between the substrate 12 and the patterned plated layers 15 formed by exposure curing, the adhesiveness of the both is increased.

Hereinafter, the primer layer is described.

The thickness of the primer layer is not particularly limited, but, generally, the thickness is preferably 0.01 to 100 µm, more preferably 0.05 to 20 µm, and even more preferably 0.05 to 10 µm.

The material of the primer layer is not particularly limited, and is preferably a resin having satisfactory adhesiveness to the substrate. Specific examples of the resin include a thermosetting resin, a thermoplastic resin, or a mixture thereof, and examples of the thermosetting resin include an epoxy resin, a phenol resin, a polyimide resin, a polyester resin, a bismaleimide resin, a polyolefin resin, or an isocyanate resin. Examples of the thermoplastic resin include a phenoxy resin, polyether sulfone, polysulfone, polyphenylene sulfone, polyphenylene sulfide, polyphenyl ether, polyether imide, or an acrylonitrile-butadiene-styrene copolymer (ABS) resin.

The method of forming the primer layer is not particularly limited, and examples thereof include a method of laminating the used resin on the substrate or a method of dissolved required components in a dissolvable solvent, coating the substrate surface by a coating method.

### <<First deformation example of first embodiment>>

Hereinafter, a first deformation example of the first embodiment of the method of manufacturing the conductive laminate according to the present invention is described above.

According to the first embodiment, the aspect in which the metal layer is disposed only on one surface side of the substrate is described, but the present invention is not limited to the aspect, and the metal layer may be disposed on both sides of the substrate.

That is, the first deformation example of the first embodiment of the method of manufacturing the conductive laminate includes a step (Step A2) of forming patterned plated layer precursor layers on both main surfaces of the substrate and obtaining plated layer precursor layer-attached substrates, a step (Step B2) of forming the plated layer precursor layer-attached substrates in a three-dimensional shape including curved surfaces, a step (Step C2) of applying energy to patterned plated layer precursors and forming patterned plated layers, a step (Step E2) of applying a plating catalyst or a precursor thereof, and a step (Step D2) of performing a plating treatment and forming pattern-shaped metal layers on the patterned plated layers.

Hereinafter, each of the steps of the first deformation example of the first embodiment is described, but the procedure and used materials in each of the steps in the first deformation example of the first embodiment is the same as those in the first embodiment, except for including a step of forming the patterned plated layers on both main surfaces of the substrate. Accordingly, in the description below, only Step A2 is described, and the other description is omitted.

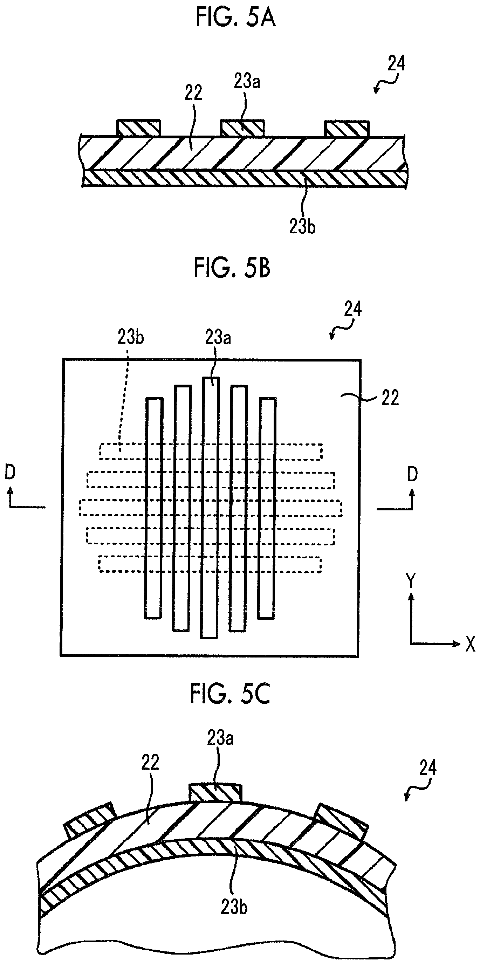

In Figs. 5A to 5C, schematic views describing Step A2 are illustrated. Fig. 5B is a top view of a plated layer precursor layer-attached substrate 24 formed in Step A2, and Fig. 5A is a cross-sectional view of the D-D cross section thereof. Fig. 5C is a cross-sectional view of the plated layer precursor layer-attached substrate 24 obtained in Step B2.

In a case where metal wiring is formed on both of the main surfaces of the substrate, as illustrated in Figs. 5A and 5B, in Step A2, patterned plated layer precursor layers 23a are disposed on one main surface of a substrate 22, and patterned plated layer precursor layers 23b are disposed on the other main surface of the substrate 22. The method of forming the patterned plated layer precursor layers 23a and 23b is the same as that in the first embodiment, and examples thereof include a method of applying the plated layer forming composition to the substrate 22 in a patterned shape.

As illustrated in Fig. 5B, the patterned plated layer precursor layers 23a are layers extending in the first direction (Y direction) and being arranged with a predetermined interval in the second direction (X direction) orthogonal to the first direction, and the patterned plated layer precursor layers 23b are layers extending in the second direction (X direction) and being arranged with a predetermined interval in the first direction (Y direction) orthogonal to the second direction.

In a case where the metal layers are disposed on the patterned plated layer precursor layers 23a and 23b as illustrated in Fig. 5B, the metal layers function as the first sensor electrode that elongates in the first direction of the touch sensor and the second sensor electrode that elongates in the second direction.

In a case where the plated layer precursor layer-attached substrate 24 illustrated in Fig. 5A is deformed such that a hemisphere portion is formed in the same manner as the first embodiment as described above, it is possible to obtain the plated layer precursor layer-attached substrate 24 having a three-dimensional shape including a curved surface as illustrated in Fig. 5C.

### <<Second deformation example of first embodiment>>

Hereinafter, a second deformation example of the first embodiment of the method of manufacturing the conductive laminate according to the present invention is described.

In the first embodiment, the aspect of deforming the central portion of the substrate 12 is described, but the present invention is not limited to this aspect.

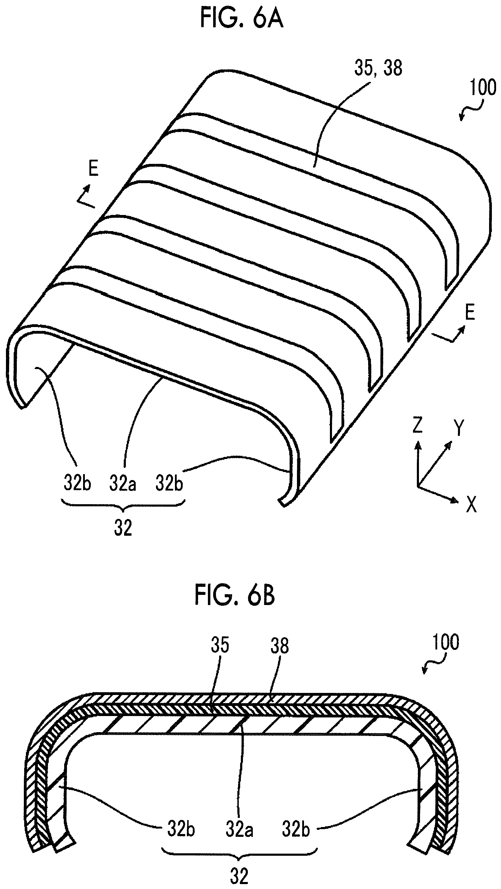

For example, as illustrated in Figs. 6A and 6B, a conductive laminate 100 may be obtained by deforming the substrate such that a substrate 32 having a flat portion 32a and a curved portion 32b connected to the flat portion 32a and including curved surfaces disposed on the both end sides thereof is obtained.

The conductive laminate 100 has a patterned plated layer 35 projecting to the X direction in the drawing on one surface of the substrate 32 on one surface and a metal layer 38 disposed on the patterned plated layer 35.

### <<Second embodiment>>

Hereinafter, a second embodiment of the method of manufacturing the conductive laminate according to the present invention is described.

The second embodiment of the method of manufacturing the conductive laminate according to the present invention has Step A3 of forming pattern-shaped plated layer precursor layers having a functional group and a polymerizable group interacting with a plating catalyst or a precursor thereof on a substrate and including a plating catalyst or a precursor and obtaining a plated layer precursor layer-attached substrate, Step B3 of deforming the plated layer precursor layer-attached substrate such that at least a portion of the plated layer precursor layer is deformed and forming a three-dimensional shape including a curved surface, Step C3 of applying energy to the patterned plated layer precursor and forming the pattern-shaped plated layer, and Step D3 of performing a plating treatment and forming a pattern-shaped metal layer on the patterned plated layer.

According to the second embodiment, pattern-shaped plated layer precursor layers having an interacting group and a polymerizable group and including a plating catalyst or a precursor thereof is formed on the substrate, a three-dimensional shape including a curved surface is formed by deforming the obtained plated layer precursor layer-attached substrate, energy is applied, and a plating treatment is performed. That is, the conductive laminate can be manufactured without performing Treatment E1 of applying a plating catalyst or a precursor thereof as described in the first embodiment, and the manufacturing process can be simplified.

The second embodiment has the same procedure as the first embodiment except for manufacturing the pattern-shaped plated layer precursor layers including the plating catalyst or the precursor thereof first without independently performing a treatment of applying a plating catalyst or a precursor thereof.

In a case where the pattern-shaped plated layer is formed by applying the plated layer forming composition including Composition Y and a plating catalyst or a precursor thereof on the substrate in a patterned shape, after a complex obtained by dispersing a plating catalyst in a compound having an interacting group is prepared in advance, and a compound having a polymerizable group is added, so as to prepare the plated layer forming composition.

Also in the second embodiment, in the same manner as in the first embodiment, elongations at break of the substrate and the plated layer precursor layer are preferably 50% or greater at 200°C and the suitable range thereof is as described above.

### <<Third embodiment>>

Below, a third embodiment of the method of manufacturing the conductive laminate according to the present invention is described.

The third embodiment of the method of manufacturing the conductive laminate according to the present invention includes Step F1 of forming a pattern-shaped plated layer having a functional group interacting with a plating catalyst or a precursor thereof on a substrate and obtaining a plated layer-attached substrate, Step G1 of deforming the plated layer-attached substrate such that at least a portion of the plated layer is deformed and forming a three-dimensional shape including a curved surface, Step H1 of performing a plating treatment and Step H1 a pattern-shaped metal layer on the plated layer, and Step I1 of applying a plating catalyst or a precursor thereof to the pattern-shaped plated layer after Step G1 and before Step H1.

According to the third embodiment, the pattern-shaped plated layer including an interacting group is formed on the substrate, a three-dimensional shape including a curved surface is formed by deforming the obtained plated layer-attached substrate, a plating catalyst or a precursor thereof is applied, and a plating treatment is performed. That is, the conductive laminate can be manufactured without performing a treatment of applying energy to the plated layer precursor layer as in the first embodiment, and thus the manufacturing process can be simplified.

The plated layer-attached substrate obtained in Step F1 includes a substrate and a pattern-shaped plated layer which is at least disposed at a position at which a curved surface is formed on the substrate by Step G1 described below and includes a functional group interacting with a plating catalyst or a precursor thereof.

Step F1 is preferably a step of applying a plated layer forming composition including a compound (particularly, a non-polymerizable compound having an interacting group is preferable) having an interacting group on a substrate in a patterned shape and forming a pattern-shaped plated layer. The non-polymerizable compound having an interacting group corresponds to the compound having an interacting group and not having a polymerizable group.

The definition of the compound having an interacting group used in this step has the same meaning as that of the compound having an interacting group included in Composition Y used in the first embodiment described above. The expression "non-polymerizable compound" means that a polymerizable group is substantially not included in the compound, and the content thereof in the compound is preferably less than 2 mass%, more preferably less than 1 mass%, and even more preferably less than 0.1 mass%. The definition of the "polymerizable group" is the same as the polymerizable group included in Compound X used in the first embodiment described above.

The method of applying the plated layer forming composition includes a method described in Step A1 of the first embodiment.

Step G1 is a step of deforming the plated layer-attached substrate such that at least a portion of the plated layer is deformed and forming a three-dimensional shape including a curved surface.

The procedure of Step G1 is the same as the procedure of Step B1 of the first embodiment except for using the plated layer-attached substrate instead of the plated layer precursor layer-attached substrate described in Step B1 of the first embodiment described above.

Step H1 is a step of performing a plating treatment on the pattern-shaped plated layer and forming a pattern-shaped metal layer on the plated layer.

The procedure of Step H1 is the same as the procedure of Step D1 of the first embodiment described above.

Step I1 is a step of applying a plating catalyst or a precursor to the pattern-shaped plated layer after Step F1 and before Step G1.

The procedure of Step I1 is the same as the procedure of Step E1 of the first embodiment described above.

According to the present embodiment, in view of formability, all of the elongations at break of the substrate and the plated layer (which is the patterned plated layer) at 200°C are preferably 50% or greater and more preferably 100% or greater. According to the present invention, as the substrate or the plated layer, ones that do not break at 200°C and ones of which the melting point is lower than 200°C and cannot be measured can be used in the same manner.

Here, the elongations at break of the substrate or the plated layer at 200°C refer to an elongation percentage in a case where, while a test piece for measuring an elongation at break formed with the substrate or the plated layer of 150 mm×10 mm (film thickness 100 µm) is heated to 200°C, a tensile test is performed at a chuck distance of 100 mm and a tensile rate of 20 mm/minutes, and the substrate or the plated layer is broken.

The elongation at break of the plated layer can be adjusted with materials of the resin and the solvent and quantity ratios thereof.

### <<Fourth embodiment>>

Hereinafter, a fourth embodiment of the method of manufacturing a conductive laminate according to the present invention is described.

The fourth embodiment of the method of manufacturing a conductive laminate according to the present invention includes Step F2 of forming a pattern-shaped plated layer having a functional group interacting with a plating catalyst or a precursor thereof and including a plating catalyst or a precursor thereof on a substrate and obtaining a plated layer-attached substrate, Step G2 of deforming the plated layer-attached substrate such that at least a portion of the plated layer is deformed and forming a three-dimensional shape including a curved surface, and Step H2 of performing a plating treatment on the pattern-shaped plated layer and forming a pattern-shaped metal layer on the plated layer.

According to the fourth embodiment, the pattern-shaped plated layer including an interacting group and a plating catalyst or a precursor thereof is formed on the substrate, a three-dimensional shape including a curved surface is formed by deforming the obtained plated layer-attached substrate, and a plating treatment is performed. That is, the conductive laminate can be manufactured without performing a treatment of applying energy to a plated layer precursor layer and performing a treatment of applying a plating catalyst or a precursor thereof as in the first embodiment and the manufacturing process can be simplified.

Step F2 is preferably a step of applying the plated layer forming composition including a compound (particularly a non-polymerizable compound having an interacting group is preferable) having an interacting group and a plating catalyst or a precursor thereof on the substrate in a patterned shape and forming a pattern-shaped plated layer. The non-polymerizable compound having an interacting group corresponds to a compound having an interacting group and not having a polymerizable group.

The definition of the compound having an interacting group used in this step is the same as that of the compound having an interacting group included in Composition Y used in the first embodiment described above. The expression "non-polymerizable compound" means that a polymerizable group is substantially not included in the compound, and the content thereof in the compound is preferably less than 2 mass%, more preferably less than 1 mass%, and even more preferably less than 0.1 mass%. The definition of the "polymerizable group" is the same as the polymerizable group included in Compound X used in the first embodiment described above.

The definition of the plating catalyst or the precursor thereof is as described above.

The compound having an interacting group and the plating catalyst or the precursor thereof are independently added so as to prepare the plated layer forming composition, or other components may be added after a complex obtained by dispersing a plating catalyst to a compound having an interacting group is prepared in advance, so as to prepare the plated layer forming composition.

Examples of the method of applying the plated layer forming composition include a method described in Step A1 of the first embodiment.

Step G2 is a step of deforming the plated layer-attached substrate such that at least a portion of the plated layer is deformed and forming a three-dimensional shape including a curved surface.

The procedure of Step G2 is the same as that of Step B1 of the first embodiment except for using the plated layer-attached substrate instead of the plated layer precursor layer-attached substrate described in Step B1 of the first embodiment described above.

Step H2 is a step of performing a plating treatment on the pattern-shaped plated layer and forming the pattern-shaped metal layer on the plated layer.

The procedure of Step H2 is the same as that of Step D1 of the first embodiment described above.

According to the fourth embodiment, in the same manner as the third embodiment, the elongation at break of the substrate or the plated layer at 200°C is preferably 50% or greater and the suitable ranges thereof are also the same.

### <<Fifth embodiment>>

Hereinafter, a fifth embodiment of the method of manufacturing the conductive laminate according to the present invention is described.

The fifth embodiment of the method of manufacturing the conductive laminate according to the present invention includes Step F3 of forming a pattern-shaped plated layer having a functional group interacting with a plating catalyst or a precursor thereof on a substrate and obtaining a plated layer-attached substrate, Step G3 of deforming the plated layer-attached substrate such that at least a portion of the plated layer is deformed and forming a three-dimensional shape including a curved surface, Step H3 of performing a plating treatment to the pattern-shaped plated layer and forming a pattern-shaped metal layer on the plated layer, and Step 13 of applying a plating catalyst or a precursor thereof to the pattern-shaped plated layer after Step G3 and before Step H3.

Step F3 of obtaining the plated layer-attached substrate of the fifth embodiment is a step of forming the plated layer precursor layer including an interacting group on the substrate, applying (for example, exposure) energy in a patterned shape, perform development, and forming a patterned plated layer-attached substrate.

According to the fifth embodiment, first, the plated layer-attached substrate is formed in the above step, the obtained plated layer-attached substrate subsequently deformed, a three-dimensional shape including a curved surface is formed, a plating treatment or a precursor thereof is applied, and a plating treatment is performed.

The fifth embodiment is different from the first embodiment in that performing Step G3 of forming a three-dimensional shape including a curved surface after Step F3 of obtaining the plated layer-attached substrate is performed. Here, in a case where a material that is cured by the energy application as in the first and fifth embodiments, as in the first embodiment, it is desired to perform a step of applying energy to the plated layer precursor layer after the step of forming the three-dimensional shape including a curved surface is performed, performing development, and forming the patterned plated layer-attached substrate. In a case where the above procedure is performed, for example, also in a case where the step of forming the three-dimensional shape including a curved surface is performed at a low temperature so as to form the conductive laminate, the substrate can be deformed without generating cracks or breaks in the plated layer.

As various materials used in the fifth embodiment, respective materials described in the first embodiment can be used.

The energy applying step and the development step included in Step F3 of obtaining the plated layer-attached substrate is not particularly limited. Examples of the energy applying step include the method described in the patterned plated layer precursor layers 13.

The suitable aspect in a case where the pattern-shaped plated layer is manufactured include an aspect of including a step of forming a solid film of the plated layer precursor layer on the substrate, a step (hereinafter, referred to as an "exposure step") of exposing the plated layer precursor layer by irradiating the plated layer precursor layer with actinic rays or radiation, and a step (hereinafter, referred to as a "development step") of developing (for example, water development or alkali development) the plated layer after exposure and forming the pattern-shaped plated layer.

Specifically, for example, the plated layer precursor layer is formed by a coating method described below, the plated layer precursor layer is exposed by being irradiated with actinic rays or radiation via a predetermined mask pattern and only a coated film portion irradiated with light is crosslinked (exposure step), and developing is performed with water or an alkali developer (development step), so as to form the pattern-shaped plated layer.

Hereinafter, respective steps in the aspect are described.

As the method of applying a solid film of the plated layer precursor layer to the substrate, various coating methods such as spin coating, slit coating, an ink jet method, spray coating, spin coating, cast coating, roll coating, and a screen printing method can be applied. However, in view of continuous production, roll coating is particularly preferable.

The composition with which the substrate is coated is dried generally under the conditions of 60°C to 200°C for about 15 seconds to 10 minutes, so as to form the plated layer precursor layer.

### [Exposure step]

In the exposure step, exposure is performed by irradiating the plated layer precursor layer with actinic rays or radiation via a mask and only the coated film portion irradiated with light is crosslinked.

The exposure is preferably performed by the irradiation with radiation, and as the radiation that can be used in a case of exposure, particularly, ultraviolet rays such as, g rays, h rays, or i rays are preferably used, and a high pressure mercury lamp is preferable as the light source. The irradiation intensity is preferably 0.01 mJ/cm² to 3,000 mJ/cm² and more preferably 0.1 mJ/cm² to 2,000 mJ/cm².

### [Development step]

Subsequent to the exposure step, the development treatment (development step) is performed, and a portion which is not irradiated with light in the exposure step is eluted into the developer. Accordingly, only the photocrosslinked portion remains.

It is desirable that water or an alkali developer is used as a developer. The development temperature is generally 20°C to 60°C, and the developing time is 20 seconds to 600 seconds.

With respect to the alkali developer, examples of the inorganic developer include an alkali aqueous solution obtained by dissolving an alkaline compound such as sodium hydroxide, potassium hydroxide, sodium carbonate, sodium hydrogencarbonate, sodium silicate, or sodium metasilicate such that the concentration thereof becomes 0.001 to 10 mass% and preferably 0.005 to 0.5 mass%. Examples of the organic alkali developer include an alkali aqueous solution obtained by dissolving an alkaline compound such as ammonia water, ethylamine, diethylamine, dimethylethanolamine, tetramethylammonium hydroxide, tetraethylammonium hydroxide, tetrapropylammonium hydroxide, tetrabutylammonium hydroxide, benzyltrimethylammonium hydroxide, choline, pyrrole, piperidine, or 1,8-diazabicyclo-[5,4,0]-7-undecene such that the concentration is 0.001 to 10 mass% and preferably 0.005 to 0.5 mass%. A water-soluble organic solvent such as methanol or ethanol, a surfactant, or the like can be added to the alkali aqueous solution by an appropriate amount. In a case where a developer consisting of an alkali aqueous solution is used, washing (rinsing) with pure water is generally performed after the development.

Step G3 is a step of deforming the plated layer-attached substrate such that at least a portion of the plated layer is deformed and a three-dimensional shape including a curved surface is formed.

The procedure of Step G3 is the same as that of Step B1 of the first embodiment, except for using the plated layer-attached substrate instead of the plated layer precursor layer-attached substrate described in Step B1 of the first embodiment described above.

Also in the fifth embodiment, in the same manner as in the third embodiment, the elongation at break of the substrate or the plated layer at 200°C is preferably 50% or greater and the suitable ranges thereof are also the same.

Step H3 is a step of performing a plating treatment on the pattern-shaped plated layer and forming a pattern-shaped metal layer on the plated layer.

The procedure of Step H3 is the same as the procedure of Step D1 according to the first embodiment described above.

Step 13 is a step of applying a plating catalyst or a precursor thereof to the pattern-shaped plated layer after Step F3 and before Step G3.

The procedure of Step 13 is the same as that of Step E1 of the first embodiment described above.

### <<Sixth embodiment>>

Hereinafter, a sixth embodiment of the method of manufacturing the conductive laminate according to the present invention is described.

The sixth embodiment of the method of manufacturing the conductive laminate according to the present invention includes Step F4 of forming the pattern-shaped plated layer having a functional group interacting with a plating catalyst or a precursor thereof and including a plating catalyst or a precursor thereof on a substrate and obtaining a plated layer-attached substrate, Step G4 of deforming the plated layer-attached substrate such that at least a portion of the plated layer is deformed and forming the three-dimensional shape including a curved surface, and Step H4 of performing a plating treatment on the pattern-shaped plated layer and forming a pattern-shaped metal layer on the plated layer.

Here, Step F4 of obtaining the plated layer-attached substrate is a step of forming the plated layer precursor layer including an interacting group and including a plating catalyst or a precursor thereof on the substrate, applying (for example, exposing) energy to the plated layer precursor layer in a patterned shape, performing development, and forming the patterned plated layer-attached substrate.

As various materials used in the sixth embodiment, various materials described in the first embodiment can be used.

According to the sixth embodiment, the plated layer precursor layer including an interacting group and a plating catalyst or a precursor thereof is formed, energy is applied (for example, exposed) to the plated layer precursor layer, development is performed, the patterned plated layer-attached substrate is formed, the obtained plated layer-attached substrate is deformed, a three-dimensional shape including a curved surface is formed, and a plating treatment is performed.

That is, the conductive laminate can be manufactured without performing a treatment of applying a plating catalyst or a precursor thereof as in the fifth embodiment and thus the manufacturing process can be simplified.

According to the sixth embodiment, the same procedure as in the fifth embodiment is performed, except for manufacturing the pattern-shaped plated layer-attached substrate including a plating catalyst or a precursor thereof in advance without independently performing a treatment of applying a plating catalyst or a precursor thereof.

Also in the sixth embodiment, in the same manner as in the fifth embodiment, the elongation at break of the substrate or the plated layer at 200°C is preferably 50% or greater and the suitable ranges thereof are also the same.

### <Plated layer precursor layer-attached substrate>

The plated layer precursor layer-attached substrate according to the present invention is used in the manufacturing of the conductive laminate having a three-dimensional shape including a curved surface and has a substrate and a pattern-shaped plated layer precursor layer which is at least disposed at a position at which the curved surface is formed on the substrate and which has a functional group interacting with a plating catalyst or a precursor thereof and a polymerizable group. The plated layer precursor layer-attached substrate according to the present invention corresponds to the plated layer precursor layer-attached substrate obtained in Step A (for example, Step A1 described in the first embodiment) in the method of manufacturing the conductive laminate according to the present invention.

The materials of the substrate and the plated layer precursor layer are not particularly limited, as long as the materials can be formed in a three-dimensional shape including a curved surface. The materials are the same as the various materials of the substrate and the plated layer precursor layer described above in the method of manufacturing the conductive laminate according to the present invention and the suitable aspect thereof is also the same.

### <Plated layer-attached substrate>

The plated layer-attached substrate (hereinafter, referred to as an "unformed plated layer-attached substrate") according to the present invention is used in the manufacturing of the conductive laminate having the three-dimensional shape including the curved surface and has a substrate and a pattern-shaped plated layer which is at least disposed at a position at which the curved surface is formed on the substrate and which includes a functional group interacting with a plating catalyst or a precursor thereof. The plated layer-attached substrate according to the present invention corresponds to the plated layer-attached substrate obtained in Step F (for example, Step F1 described in the third embodiment) of the method of manufacturing the conductive laminate according to the present invention.

The materials of the substrate and the plated layer are not particularly limited, as long as the materials can be formed in a three-dimensional shape including a curved surface. The materials are the same as the various materials of the substrate and the plated layer described above in the method of manufacturing the conductive laminate according to the present invention and the suitable aspect thereof is also the same.

The plated layer-attached substrate in another aspect of the present invention includes a substrate having a three-dimensional shape at least including a curved surface and a pattern-shaped plated layer disposed on the curved surface of the substrate and including a functional group interacting with a plating catalyst or a precursor thereof. That is, the plated layer-attached substrate according to the present aspect corresponds to a substrate (for example, a plated layer-attached substrate obtained in Step G1 described in the third embodiment) obtained by forming the unformed plated layer-attached substrate described above in a three-dimensional shape including a curved surface.

### <Use>

The conductive laminate obtained in the manufacturing method according to the present invention and the conductive laminate according to the present invention can be applied to various uses, and can be applied to various uses such as a touch panel (or a touch panel sensor), a touch pad (for a touch pad sensor), a semiconductor chip, various electric wiring plates, flexible printed circuits (FPC), Chip on Film (COF), Tape Automated Bonding (TAB), antennas, a multiple-layered wiring substrate, or a mother board. Among these, the conductive laminate is preferably used in a touch sensor (an electrostatic capacitive type touch sensor such as a touch panel sensor or a touch pad sensor). In a case where the conductive laminate is applied to a touch sensor, a patterned metal layer in the conductive laminate functions as a detection electrode or lead-out wiring in the touch sensor.

According to the present specification, the touch panel is intended to be a combination of various display devices (for example, a liquid crystal display device and an organic electroluminescence (EL) display device), and the touch pad is intended to be a device such as a mouse pad not including a display device.

The conductive laminate obtained in the manufacturing method according to the present invention and the conductive laminate according to the present invention can be used as a heating element. That is, the temperature of the patterned metal layer increases by causing an electric current to pass through the patterned metal layer, and the patterned metal layer functions as a thermoelectric wire. As a result, the conductive laminate functions as a heating element. Specific uses thereof include uses as on-vehicle headlights or rear glasses. In that case, the patterned metal layer in the conductive laminate functions as a heat wire in the headlight or rear glass.

### Examples

Hereinafter, the present invention is described in detail with reference to the examples, but the present invention is not limited thereto.

### [Example 1]

### <Preparation of primer layer forming composition 1>

| | |
|---|---|
| Cyclopentanone | 90 mass% |
| Zetpol0020 (manufactured by Zeon Corporation) | 10 mass% |

The above components were mixed so as to obtain a primer layer forming composition 1.

### <Preparation of plated layer forming composition 1>

| | |
|---|---|
| 2-Propanol | 84.7 mass% |
| Polyacrylic acid | 9 mass% |
| Compound (in Formula (A), R was a hydrogen atom) represented byFormula(A) | 6 mass% |
| IRGACURE127 (manufactured by BASF SE) | 0.3 mass% |

The above components were mixed so as to obtain a plated layer forming composition 1.

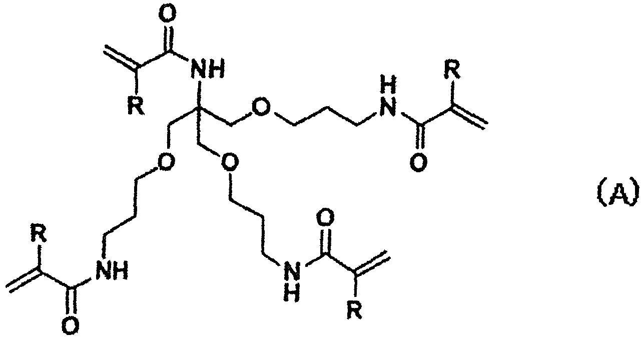

### <Manufacturing of Conductive Laminate S-1>

A conductive laminate in the first embodiment of the manufacturing method of the present invention was manufactured by using the plated layer forming composition 1.

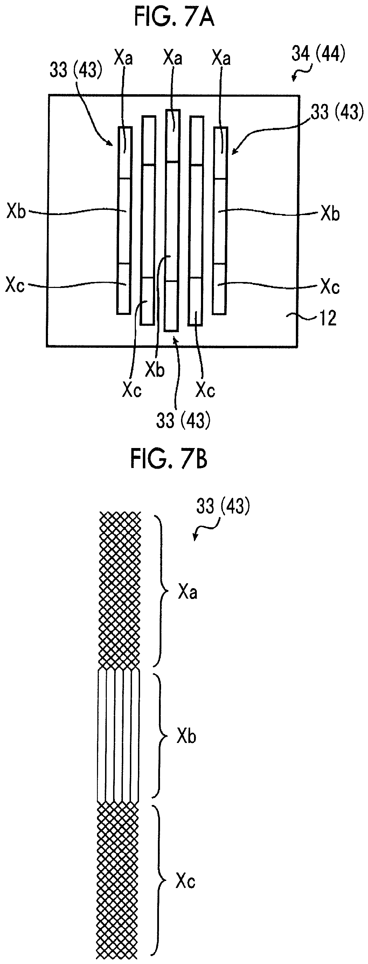

Specifically, a 1 mm-thick acrylic plate (manufactured by Acrysunday Co., Ltd.) (corresponding to the substrate 12) was coated with the primer layer forming composition 1 such that a dry film thickness was 3 µm and a primer layer was formed. The plated layer forming composition 1 was subjected to screen printing thereon so as to have patterns illustrated in Figs. 7A and 7B, and five plated layer precursor layers 33 were formed (dry film thickness: 0.5 µm).

Here, Fig. 7A is a top view schematically illustrating a plated layer precursor layer-attached substrate 34 (a plated layer-attached substrate 44 in which a plated layer 43 was formed on the substrate 12 as manufactured in Examples 2 and 3 and the like described below) manufactured in Example 1, and Fig. 7B is a partially enlarged view thereof.

As illustrated in Fig. 7B, a pattern of a plated layer precursor layer 33 was constituted such that an area in which curvature increased had line patterns Xb (L/S=100 µm/900 µm) and the other areas Xa had a mesh pattern (opening ratio: 74%). The width of each of the patterned plated layer precursor layers 33 was 5 mm, and an interval of each of the plated layer precursor layers 33 was 5 mm. The lengths of Xa and Xc in each of the plated layer precursor layers 33 were 20 mm, and the lengths of Xb in the plated layer precursor layers 33 were 35 mm, 45 mm, 50 mm, 45 mm, and 35 mm from the left side of Fig. 7A.

Subsequently, a patterned portion that has the plated layer precursor layer-attached substrate 34 was cut into a circular shape of 100 mmϕ and was fixed to a frame having an outer diameter of 100 mmϕ and an inner diameter of 90 mmϕ. Subsequently, the plated layer precursor layer-attached substrate 34 in a circular shape of 100 mmϕ which was fixed to the frame was introduced to a 200°C oven for 10 minutes and was sucked by using a pipe having an outer diameter of 80 mmϕ and an inner diameter of 70 mmϕ immediately after being taken out of the oven, and a central portion of the plated layer precursor layer-attached substrate 34 was deformed in a hemispherical shape (see Fig. 2B). After the obtained plated layer precursor layer-attached substrate 34 having a hemispherical shape was UV-irradiated (energy amount: 2 J, wavelength: 256 nm), the plated layer precursor layer-attached substrate 34 was immersed in 1 mass% of sodium hydrogencarbonate for five minutes, and a patterned plated layer was formed.

Subsequently, the substrate on which the patterned plated layer was formed was immersed in a solution obtained by diluting only MAT-2A of a Pd catalyst applying solution MAT-2 (manufactured by C. Uyemura & Co., Ltd.) by five times at room temperature for five minutes and was washed with pure water twice. Subsequently, the obtained substrate was immersed at 36°C in a reducing agent MAB (manufactured by C. Uyemura & Co., Ltd.) for five minutes and was washed with pure water twice. Thereafter, the obtained substrate was immersed in an electroless plating solution THRU-CUP PEA (manufactured by C. Uyemura & Co., Ltd.) at room temperature for 60 minutes and was washed with pure water, a patterned metal layer was formed, and Wiring Substrate (conductive laminate) S-1 having a hemispherical shape was obtained (see Fig. 4B).

### [Example 2]

### <Adjustment of plated layer forming composition 2>

0.25 g of block-type polyisocyanate (DURANATE (registered trademark) SBN-70D manufactured by Asahi Kasei Chemicals Corporation) and 1.2 g of an isocyanate curing acrylic resin (ACRICK (registered trademark) A-817 manufactured by DIC Corporation) were dissolved in 4.0 g of methyl ethyl ketone, so as to obtain a curable prepolymer solution. A solution obtained by dissolving 0.1 g of Pd (HPS-NOct₃Cl) prepared by a method described below, 1.5 g of 3-aminopropyltrimethoxysilane (manufactured by Tokyo Chemical Industry Co., Ltd.), and 0.5 g of polyvinylpyrrolidone (manufactured by Tokyo Chemical Industry Co., Ltd., polyvinylpyrrolidone K90, viscosity average molecular weight: 630,000) as a viscosity improver, in 1.5 g of n-propanol was added to this solution, so as to prepare a plated layer forming composition 2. A so-called plating catalyst was included in the plated layer forming composition 2.

### <Preparation of Pd (HPS-NOct₃Cl)>

4.3 g of palladium acetate (manufactured by Kawaken Fine Chemicals Co., Ltd.) and 200 g of chloroform were put into a one liter two-neck flask and were stirred until the solution become uniform. A solution obtained by dissolving 18.0 g of HPS-NOct₃Cl manufactured according to [Synthesis Example 2] disclosed in JP2014-159620A in 200 g of chloroform was added to this solution by using a dropping funnel. The inside of this dropping funnel was washed off to the above reaction flask by using 100 g of ethanol. The mixture was stirred at 60°C for 17 hours.

After the mixture was cooled to a liquid temperature of 30°C, the solvent was distilled off from the mixture. The obtained residue was dissolved in 300 g of tetrahydrofuran, and the obtained solution was cooled to 0°C. This solution was added to 6,000 g of isopropanol at 0°C, and reprecipitation purification was performed. The precipitated polymer was recovered by vacuum filtration and was vacuum-dried at 60°C to obtain 19.9 g of a complex (Pd[HPS-NOct₃Cl]) of a hyperbranched polymer having an ammonium group at the molecular terminal and Pd particles as a black powder.

In the same manner as in Example 1, the plated layer forming composition 2 was subjected to screen printing on a 1 mm-thick acrylic plate (manufactured by Acrysunday Co., Ltd.) on which the primer layer was formed so as to obtain the pattern illustrated in Figs. 7A and 7B and the plated layer 43 was formed (dry film thickness: 0.5 µm). Subsequently, the obtained portion having the pattern of the plated layer-attached substrate 44 was cut into a circular shape of 100 mmϕ and was fixed to a frame having an outer diameter of 100 mmϕ and an inner diameter of 90 mmϕ. Subsequently, the plated layer-attached substrate 44 in a circular shape of 100 mmϕ which was fixed to the frame was introduced to a 200°C oven for 10 minutes and was sucked by using a pipe having an outer diameter of 80 mmϕ and an inner diameter of 70 mmϕ immediately after being taken out of the oven, and a central portion of the plated layer-attached substrate 44 was deformed in a hemispherical shape (see Fig. 2B).

Thereafter, the plated layer-attached substrate 44 having a hemispherical shape was immersed in an electroless plating solution THRU-CUP PEA (manufactured by C. Uyemura & Co., Ltd.) at room temperature for 60 minutes and was washed with pure water, a patterned metal layer was formed, and Wiring Substrate (conductive laminate) S-2 having a hemispherical shape was obtained.

### [Example 3]

3.5 g of palladium fine particles and 171.5 g of γ-alumina were dispersed and aggregated in ethanol, solid-liquid separated, and dried, and γ-alumina fine particles that held and supported the palladium fine particles were obtained. Subsequently, 90 g of ethyl cellulose was dissolved in a solution consisting of 472 g of α-terpineol and 236 g of butyl carbitol acetate, γ-alumina fine particles that holded and supported the palladium fine particles and 9 g of carbon black were further added, mixed with a triple roll mill, and dispersed, and a plated layer forming composition 3 was obtained. A so-called plating catalyst was added to the plated layer forming composition 3.

A wiring substrate (conductive laminate) S-3 was obtained in the same procedure as in Example 2 except for using the plated layer forming composition 3 instead of the plated layer forming composition 2.

The elongations at break of all of the plated layer precursor layer of Example 1, the plated layers of Examples 2 and 3, and the acrylic plates (manufactured by Acrysunday Co., Ltd.) used in Examples 1 to 3 as the substrates at 200°C were 50% or greater. The break test was performed under the following conditions.

### <Break test>

Films were formed of the plated layer forming compositions of Examples 1 to 3 with a petri dish made of TEFLON (registered trademark) so as to have a thickness of 100 µm, and were cut into a size of 150 mm×10 mm, and test pieces for measuring elongations at break were obtained. A tensile test of the test pieces for measuring elongations at break was performed in a chuck distance of 100 mm and a tensile rate of 20 mm/minute while heating was performed at 200°C by using an autograph AG-20kN manufactured by Shimadzu Corporation, and all of the test pieces were not broken even though being extended by 50% or greater.

In a case where the same tensile test was performed on the acrylic plate of the substrate, all of the test pieces were not broken even though being extended by 50% or greater.

### [Comparative Example 1]

Copper was vapor-deposited on a 1 mm-thick acrylic plate (manufactured by Acrysunday Co., Ltd.) on which a primer layer was formed in the same manner as in Example 1, and a copper foil having a thickness of 2 µm was formed. Subsequently, the copper foil surface was coated with a negative resist to a thickness of about 6 µm and the negative resist was dried at 90°C for 30 minutes. The negative resist was irradiated with ultraviolet light (UV light) by 100 mJ/cm² via a mask having the pattern illustrated in Figs. 7A and 7B. Subsequently, a development treatment was performed on the negative resist in a 3% sodium carbonate aqueous solution. Accordingly, a resist pattern was formed in a portion corresponding to the pattern wiring, and the resist in the other portion was removed. Subsequently, the exposed portion of the copper foil was removed by etching by using a ferric chloride solution having a specific gravity of 1.45, and the remaining resist was peeled off

Thereafter, the obtained pattern-shaped acrylic plate having copper was cut into a circular shape of 100 mmϕ and was fixed to a frame having an outer diameter of 100 mmϕ and an inner diameter of 90 mmϕ. Subsequently, the acrylic plate in a circular shape of 100 mmϕ which was fixed to the frame was introduced to a 200°C oven for 10 minutes and was sucked by using a pipe having an outer diameter of 80 mmϕ and an inner diameter of 70 mmϕ immediately after being taken out of the oven, the acrylic plate on which wiring was formed was deformed into a hemispherical shape, and a wiring substrate (conductive laminate) S-4 having a hemispherical shape was obtained.

### [Continuity evaluation of wiring]

The continuity of the wiring of Wiring Substrates S-1 to S-4 was checked, and S-1 to S-3 were conducted, but S-4 was not conducted.

### [Example 4]

A conductive laminate was manufactured in the procedure of the first deformation example of the first embodiment of the manufacturing method of the present invention by using the plated layer forming composition 1.

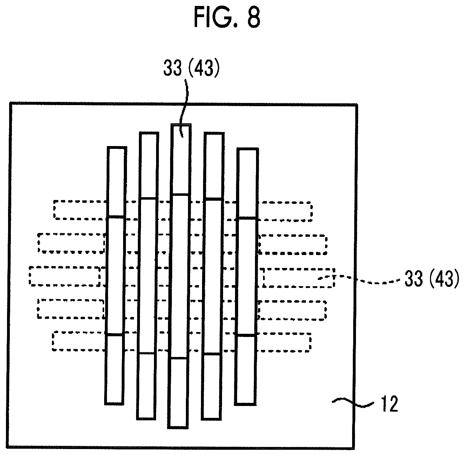

Specifically, a wiring substrate (conductive laminate) S-5 having a hemispherical shape was manufactured in the same method as in Example 1 except for disposing the pattern-shaped plated layer precursor layers 33 disposed on one surface on the substrate in Example 1 to be orthogonal to each other on both surfaces of the substrate 12 as illustrated in Fig. 8.

Fig. 8 is a top view of the pattern-shaped plated layer precursor layers 33 (and the pattern-shaped plated layers 43 manufactured in Examples 5, 6, and the like described below) manufactured in Example 4.

### [Example 5]

A wiring substrate (conductive laminate) S-6 having a hemispherical shape was manufactured in the same manner as in Example 2 except for disposing the pattern-shaped plated layers 43 disposed on one surface on the substrate in Example 2 to be orthogonal to each other on both surfaces of the substrate 12 as illustrated in Fig. 8.

### [Example 6]

A wiring substrate (conductive laminate) S-7 having a hemispherical shape was manufactured in the same manner as in Example 3 except for disposing the pattern-shaped plated layers 43 disposed on one surface on the substrate in Example 3 to be orthogonal to each other on the both surfaces of the substrate 12 as illustrated in Fig. 8.

### [Continuity checking of wiring]

Lead-out wiring was further formed on each of the wiring substrates by using hemispherical shaped wiring substrates (conductive laminates) of Wiring Substrates S-5 to S-7 and was checked whether the lead-out wiring reacted as a touch sensor, and all of the lead-out wiring was reacted as touch sensors.

### [Example 7]

Wiring Substrates S-8 was obtained with the same materials and steps as in Example 1 except for changing the procedure of a "200°C oven" of Example 1 to a "150°C oven". It was checked that he wiring of Wiring Substrates S-8 was conducted. A break test was performed by using the method described in Example 1, and the elongation at break of the plated precursor layer of Example 7 at 150°C was 50% or greater.

### [Example 8]

### <Manufacturing of Conductive Substrate S-9>

A 1 mm-thick acrylic plate (manufactured by Acrysunday Co., Ltd.) was coated with the primer layer in the same manner as in Example 1. Subsequently, the primer layer was coated with a 2-propanol 6-fold diluted solution of the plated layer forming composition 1 to a thickness of 0.6 µm and dried and a coating film was obtained. Subsequently, pattern exposure (exposure amount: 1,800 mJ/cm²) was performed on the coating film by using a high pressure mercury parallel exposure machine such that patterns of Figs. 7A and 7B were formed, and then development was performed with water, to obtain the plated layer 43. Here, in Example 8, the Xb area illustrated in Fig. 7B was set to L/S=2 µm/283 µm, and the Xa area was set to have an opening ratio of 98%.

Subsequently, a portion having a pattern of the obtained plated layer-attached substrate 44 was cut into a circular shape of 100 mmϕ and was fixed to a frame having an outer diameter of 100 mmϕ and an inner diameter of 90 mmϕ. Subsequently, the plated layer-attached substrate 44 in a circular shape of 100 mmϕ which was fixed to the frame was introduced to a 200°C oven for 10 minutes and was sucked by using a pipe having an outer diameter of 80 mmϕ and an inner diameter of 70 mmϕ immediately after being taken out of the oven, and the substrate was deformed into a hemispherical shape.

Subsequently, the plated layer-attached substrate 44 having a hemispherical shape was immersed in a solution obtained by diluting only MAT-2A of a Pd catalyst applying solution MAT-2 (manufactured by C. Uyemura & Co., Ltd.) by five times at room temperature for five minutes and was washed with pure water twice. Subsequently, the obtained substrate was immersed at 36°C in a reducing agent MAB (manufactured by C. Uyemura & Co., Ltd.) for five minutes and was washed with pure water twice. Thereafter, the obtained substrate was immersed in an electroless plating solution THRU-CUP PEA (manufactured by C. Uyemura & Co., Ltd.) at room temperature for 60 minutes and was washed with pure water, and Wiring Substrates S-9 having a three-dimensional curved surface was obtained.

It was checked that the wiring of Wiring Substrates S-9 was conducted. Since in Example 8, a pattern having a small line width is formed by exposure development, it was checked that the transparency of the wiring substrate was improved compared with Example 1.

It was checked that the width (wiring width) of the pattern-shaped metal layer formed in the plating applying step was 10 µm or less in the same manner as the pattern width of the plated layer.

### [Example 9]

Wiring Substrates S-10 was obtained with the same materials and steps as in Example 8 except for changing the procedure of a "200°C oven" of Example 8 to a "150°C oven". It was checked that the wiring of Wiring Substrates S-10 was conducted, but the resistance was partially increased, and unevenness was seen. The wiring was observed with a microscope to observe something like cracks.

### <Break test>

Films were formed of the plated layer forming compositions of Examples 8 and 9 with a petri dish made of TEFLON (registered trademark) so as to have a thickness of 100 µm and were cut into a size of 150 mm×10 mm. Subsequently, pattern exposure (exposure amount: 1,800 mJ) was performed on the obtained coating film by using a coating film high pressure mercury parallel exposure machine, and test pieces for measuring elongations at break were manufactured. A break test was performed in the method disclosed in Example 1 by using the test pieces for measuring elongations at break, the elongations at break of the plated layers of Examples 8 and 9 at 200°C were 50% or greater, but elongations at break thereof at 150°C were less than 50%.

### [Example 10]

One surface of a 1 mm-thick acrylic plate was coated with the plated layer forming composition 1 in the same step of Example 8 by using the plated layer forming composition 1, a mask was matched on one surface such that the pattern of Fig. 8 was formed, an exposure development treatment was performed, and pattern forming was performed on the plated layer. Subsequently, pattern forming was performed on the plated layer in the same step such that the pattern was orthogonal to each other on the opposite surface on which pattern forming was performed. Thereafter, electroless plating was performed in the same manner as in Example 8, and Wiring Substrates S-11 having wiring on both surfaces of the three-dimensional curved surface was obtained.

Wiring Substrates S-11 was driven as a touch panel and was driven without problems.

### [Example 11]

Electric current was caused to pass through the metal layers in Wiring Substrates S-1 to 3 and 8 to 10, the temperature was increased, it was checked that the metal layer was driven as thermoelectric wire and functioned as a heating element.

### Explanation of References

- 10,100: conductive laminate
- 12,22,32: substrate
- 12a: hemisphere portion
- 12b: flat portion
- 13,23a,23b,33: patterned plated layer precursor layer
- 14,24,34: plated layer precursor layer-attached substrate
- 44: plated layer-attached substrate
- 15,35,43: patterned plated layer
- 18,38: patterned metal layer
- 31: lattice
- 30: thin line
- W: length W of one side of lattices 31
- 32a: flat portion
- 32b: curved portion
- Xa, Xc: mesh pattern
- Xb: line pattern

## Claims

1. A method of manufacturing a conductive laminate having a three-dimensional shape including a curved surface, comprising:
Step A of forming a pattern-shaped plated layer precursor layer having a functional group interacting with a plating catalyst or a precursor thereof and a polymerizable group on a substrate to obtain a plated layer precursor layer-attached substrate;
Step B of deforming the plated layer precursor layer-attached substrate such that at least a portion of the plated layer precursor layer is deformed to be formed into a three-dimensional shape including a curved surface;
Step C of applying energy to the plated layer precursor layer to form a pattern-shaped plated layer; and
Step D of performing a plating treatment on the pattern-shaped plated layer to form a pattern-shaped metal layer on the plated layer;
wherein Step E of applying a plating catalyst or a precursor thereof to the pattern-shaped plated layer is further included after Step C and before Step D, or a plating catalyst or a precursor thereof is included in the pattern-shaped plated layer precursor layer of Step A.

2. The method of manufacturing a conductive laminate according to claim 1,
wherein Step A is a step of forming the pattern-shaped plated layer precursor layer including Compound X or Composition Y on a substrate to obtain the plated layer precursor layer-attached substrate, and
wherein Step E of applying a plating catalyst or a precursor thereof to the pattern-shaped plated layer is further included after Step C and before Step D,
Compound X or Composition Y:
Compound X: a compound having a functional group interacting with a plating catalyst or a precursor thereof and a polymerizable group, and
Composition Y: a composition including a compound having a functional group interacting with a plating catalyst or a precursor thereof and a compound having a polymerizable group.

3. The method of manufacturing a conductive laminate according to claim 1 or 2,
wherein an elongation at break of each of the substrate and the plated layer precursor layer at 200°C is 50% or greater.

4. A method of manufacturing a conductive laminate having a three-dimensional shape including a curved surface, comprising:
Step F of forming a pattern-shaped plated layer having a functional group interacting with a plating catalyst or a precursor thereof on a substrate to obtain a plated layer-attached substrate;
Step G of deforming the plated layer-attached substrate such that at least a portion of the plated layer is deformed to be formed into a three-dimensional shape including a curved surface; and
Step H of performing a plating treatment on the pattern-shaped plated layer to form a pattern-shaped metal layer on the plated layer;
wherein Step I of applying a plating catalyst or a precursor thereof to the pattern-shaped plated layer is further included after Step G and before Step H, or a plating catalyst or a precursor thereof is included in the pattern-shaped plated layer of Step F.

5. The method of manufacturing a conductive laminate according to claim 4,
wherein an elongation at break of each of the substrate and the plated layer at 200°C is 50% or greater.

6. The method of manufacturing a conductive laminate according to claim 4 or 5,
wherein a width of the pattern-shaped metal layer is 10 µm or less.

7. The method of manufacturing a conductive laminate according to any one of claims 1 to 6,
wherein the plating treatment includes an electroless plating treatment.

8. A conductive laminate comprising:
a substrate having a three-dimensional shape including a curved surface;
a pattern-shaped plated layer which is disposed at least on a curved surface of the substrate and which includes a functional group interacting with a plating catalyst or a precursor thereof; and
a pattern-shaped metal layer disposed on the plated layer.

9. The conductive laminate according to claim 8,
wherein the plated layer is a layer formed by applying energy to a pattern-shaped plated layer precursor layer including Compound X or Composition Y,
Compound X: a compound having a functional group interacting with a plating catalyst or a precursor thereof and a polymerizable group, and
Composition Y: a composition including a compound having a functional group interacting with a plating catalyst or a precursor thereof and a compound having a polymerizable group.

10. The conductive laminate according to claim 8 or 9,
wherein the metal layer is a layer formed by performing a plating treatment after a plating catalyst or a precursor thereof is applied to the plated layer.

11. A plated layer precursor layer-attached substrate used in manufacturing of a conductive laminate having a three-dimensional shape including a curved surface; the plated layer precursor layer-attached substrate comprising:
a substrate; and
a pattern-shaped plated layer precursor layer which is disposed at least at a position of the substrate on which the curved surface is formed and which has a functional group interacting with a plating catalyst or a precursor thereof and a polymerizable group.

12. A plated layer-attached substrate used in manufacturing of a conductive laminate having a three-dimensional shape including a curved surface, the plated layer-attached substrate comprising:
a substrate; and
a pattern-shaped plated layer which is disposed at least at a position of the substrate on which the curved surface is formed and which includes a functional group interacting with a plating catalyst or a precursor thereof.

13. A plated layer-attached substrate comprising:
a substrate having a three-dimensional shape including a curved surface; and
a pattern-shaped plated layer which is disposed at least on a curved surface of the substrate and which includes a functional group interacting with a plating catalyst or a precursor thereof.

14. The conductive laminate according to any one of claims 8 to 10, used as a heating element.

15. A touch sensor comprising:
a conductive laminate manufactured by the manufacturing method according to any one of claims 1 to 7 or the conductive laminate according to any one of claims 8 to 10.
